# EUROPEAN PATENT APPLICATION

(11) **EP 4 648 101 A1**
(43) Date of publication of application: **12.11.2025**
(21) Application number: 23916273.8
(22) Date of filing: 25.12.2023
(51) Int. Cl.: H01L 23/48, H01L 25/07, H01L 25/18

(54) **SEMICONDUCTOR DEVICE AND VEHICLE**

(30) Priority: 12.01.2023 JP 2023002939
(71) Applicant: Rohm Co., Ltd., Kyoto-shi, Kyoto 615-8585 (JP)
(72) Inventor: HAYASHIGUCHI, Masashi, Kyoto-shi, Kyoto 615-8585 (JP)
(74) Representative: Witte, Weller & Partner Patentanwälte mbB
(86) International application number: PCT/JP2023/046399
(87) International publication number: WO 2024/150659

(57) **Abstract**

A semiconductor device comprises a first conductive layer, a first semiconductor element bonded to one side in a first direction of the first conductive layer, a first power terminal conductive to the first conductive layer and the first semiconductor element, a first sealing resin covering the first conductive layer and the first semiconductor element, and a first extension terminal conductively bonded to the first power terminal. The first power terminal has a first exposed portion exposed from the first sealing resin. The first extension terminal is conductively bonded to the first exposed portion.

## Description

### TECHNICAL FIELD

The present disclosure relates to a semiconductor device and a vehicle in which the semiconductor device is mounted.

### BACKGROUND ART

Conventionally, semiconductor devices in which semiconductor elements (such as MOSFETs and IGBTs) having switching functions are mounted are widely known, and are mainly used for power conversion. Patent document 1 discloses an example of such a semiconductor device. The semiconductor device disclosed in said document has a first wiring layer, a first semiconductor element conductively bonded to the first wiring layer, a second terminal conductive to the first wiring layer, and a sealing resin covering the first wiring layer and the first semiconductor element. The second terminal is exposed from the sealing resin.

In the semiconductor device disclosed in Patent Document 1, the portion of the second terminal exposed from the sealing resin is used for external connection with a DC power supply or the like. Here, it is desirable that the size and shape of the portion of the second terminal exposed from the sealing resin can be set more freely according to the state of use of the semiconductor device.

### PRIOR ART DOCUMENT

### Patent Document

Patent Document 1: JP-A-2022-053801

### SUMMARY OF THE INVENTION

### Problem to be solved by the Invention

An object of the present disclosure is to provide a semiconductor device that has been improved over conventional devices and a vehicle in which the semiconductor device is mounted. In particular, in view of the above circumstances, an object of the present disclosure is to provide a semiconductor device capable of increasing the degree of freedom for external connection of power terminals, and a vehicle in which the semiconductor device is mounted. The semiconductor device and the vehicle in which the semiconductor device is mounted.

### Means to solve the Problem

A semiconductor device provided according to a first aspect of the present disclosure includes a first conductive layer, a first semiconductor element bonded to one side in a first direction of the first conductive layer, a first power terminal conductive to the first conductive layer and the first semiconductor element, a first sealing resin covering the first conductive layer and the first semiconductor element, and a first extension terminal conductively bonded to the first power terminal. The first power terminal has a first exposed portion exposed externally from the first sealing resin. The first extension terminal is conductively bonded to the first exposed portion.

A semiconductor device provided according to a second aspect of the present disclosure includes a first conductive layer, a first semiconductor element bonded to one side in a first direction of the first conductive layer, a first power terminal conductive to the first conductive layer and the first semiconductor element, and a first sealing resin covering the first conductive layer and the first semiconductor element. The first power terminal has a first exposed portion exposed externally from the first sealing resin. The first exposed portion is provided with a first engagement portion.

The vehicle provided by a third aspect of the present disclosure includes a drive source and a semiconductor device. The semiconductor device has a second power terminal, a second extension terminal conductively bonded to the second power terminal, a third power terminal, and a third extension terminal conductively bonded to the third power terminal, for the semiconductor device provided by the first aspect of the present disclosure. The semiconductor device is further provided with a second semiconductor element and a second conductive layer to which the second semiconductor element is conductively bonded. The first semiconductor element is conductively bonded to the first conductive layer. The second power terminal is conductive to the second semiconductor element. The third power terminal is conductive to the second conductive layer. The first sealing resin covers the second semiconductor element and the second conductive layer.

### Advantages of the Invention

According to the above configuration, it is possible to increase the degree of freedom for the external connection of the power terminal.

Other features and advantages of the present disclosure will become more apparent from the following detailed description based on the accompanying drawings.

### BRIEF DESCRIPTION OF THE DRAWINGS

Fig. 1 is a perspective view of a semiconductor device according to a first embodiment of the present disclosure.
Fig. 2 is a plan view of the semiconductor device shown in Fig. 1.
Fig. 3 is a plan view corresponding to Fig. 2, with a first sealing resin transparent.
Fig. 4 is a partial enlarged view of Fig. 3.
Fig. 5 is a plan view corresponding to Fig. 2, with a first conductive member transparent, and a first extension terminal, two second extension terminals 72, a third extension terminal, a first sealing resin, and a second conductive member are omitted.
Fig. 6 is a right side view of the semiconductor device shown in Fig. 1.
Fig. 7 is a bottom view of the semiconductor device shown in Fig. 1.
Fig. 8 is a cross-sectional view along line VIII-VIII of Fig. 3.
Fig. 9 is a cross-sectional view along line IX-IX of Fig. 3.
Fig. 10 is a partial enlarged view of a first element shown in Fig. 9 and its surrounding area.
Fig. 11 is a partial enlarged view of a second element shown in Fig. 9 and its surrounding area.
Fig. 12 is a cross-sectional view along line XII-XII of Fig. 3.
Fig. 13 is a cross-sectional view along line XIII-XIII of Fig. 3.
Fig. 14 is a partial enlarged view of Fig. 2.
Fig. 15 is a cross-sectional view along line XV-XV of Fig. 14.
Fig. 16 is a cross-sectional view along line XVI-XVI of Fig. 14.
Fig. 17 is a partial enlarged plan view of a semiconductor device according to a first variation of the first embodiment of the present disclosure.
Fig. 18 is a cross-sectional view along line XVIII-XVIII of Fig. 17.
Fig. 19 is a partial enlarged plan view of a semiconductor device according to a second variation of the first embodiment of the present disclosure.
Fig. 20 is a cross-sectional view along line XX-XX of Fig. 19.
Fig. 21 is a cross-sectional view along line XXI-XXI of Fig. 19.
Fig. 22 is a partial enlarged plan view of a semiconductor device according to a third variation of the first embodiment of the present disclosure.
Fig. 23 is a cross-sectional view along line XXIII-XXIII of Fig. 22.
Fig. 24 is a schematic view of a vehicle in which the semiconductor device shown in Fig. 1 is mounted.
Fig. 25 is a plan view of a semiconductor device according to a second embodiment of the present disclosure.
Fig. 26 is a right side view of the semiconductor device shown in Fig. 25.
Fig. 27 is a plan view of the semiconductor device according to a third embodiment of the present disclosure.
Fig. 28 is a right side view of the semiconductor device shown in Fig. 27.
Fig. 29 is a cross-sectional view along line XXIX-XXIX of Fig. 27.
Fig. 30 is a plan view of the semiconductor device according to a fourth embodiment of the present disclosure.
Fig. 31 is a right side view of the semiconductor device shown in Fig. 30.
Fig. 32 is a cross-sectional view along line XXXII-XXXXII of Fig. 30.
Fig. 33 is a plan view of the semiconductor device according to a fifth embodiment of the present disclosure.
Fig. 34 is a cross-sectional view along line XXXIV-XXXIV of Fig. 33.
Fig. 35 is a plan view of a semiconductor device according to a sixth embodiment of the present disclosure.
Fig. 36 is a right side view of the semiconductor device shown in Fig. 35.

### MODE FOR CARRYING OUT THE INVENTION

Modes for carrying out the present disclosure will be described with reference to the accompanying drawings.

### First embodiment:

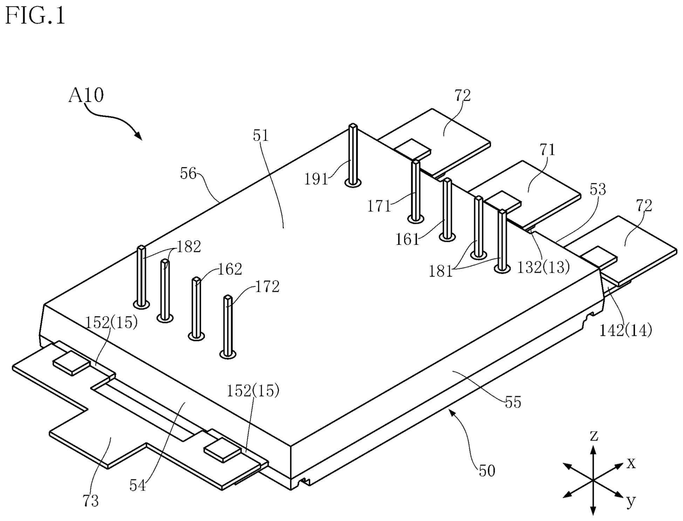

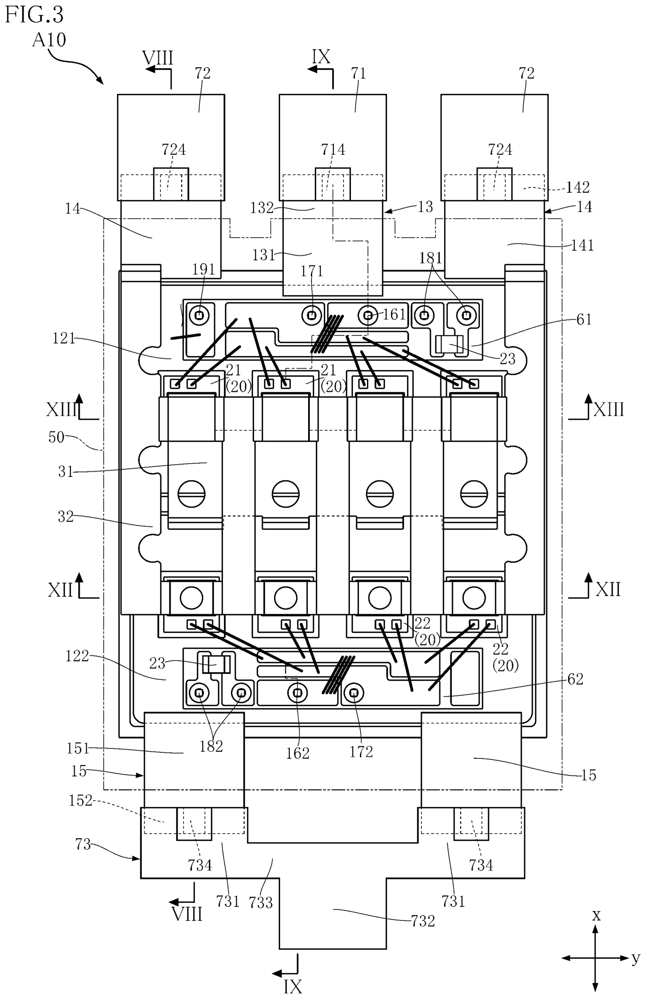

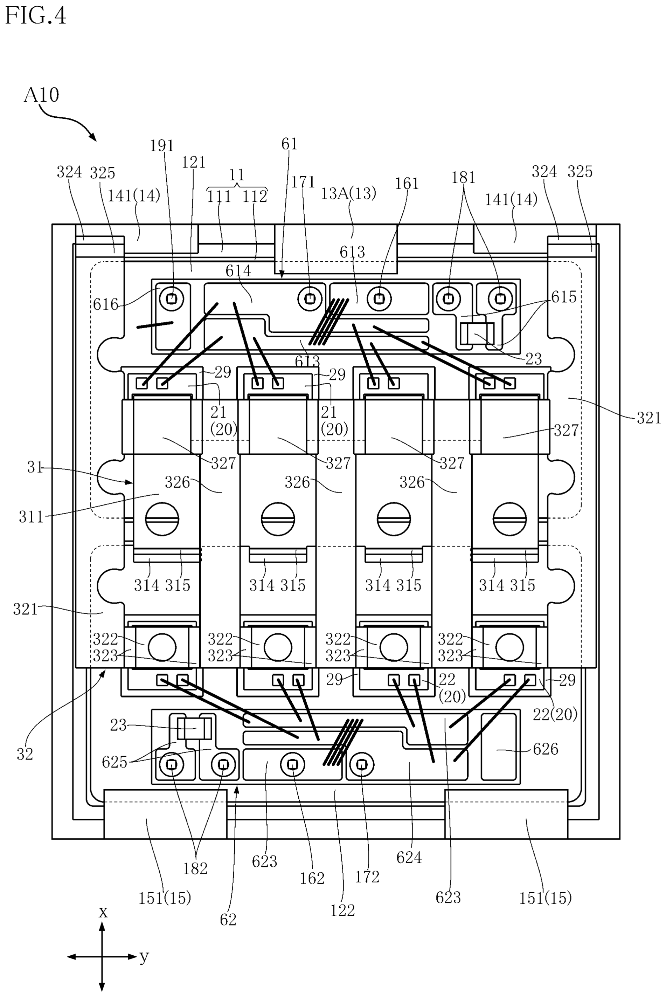

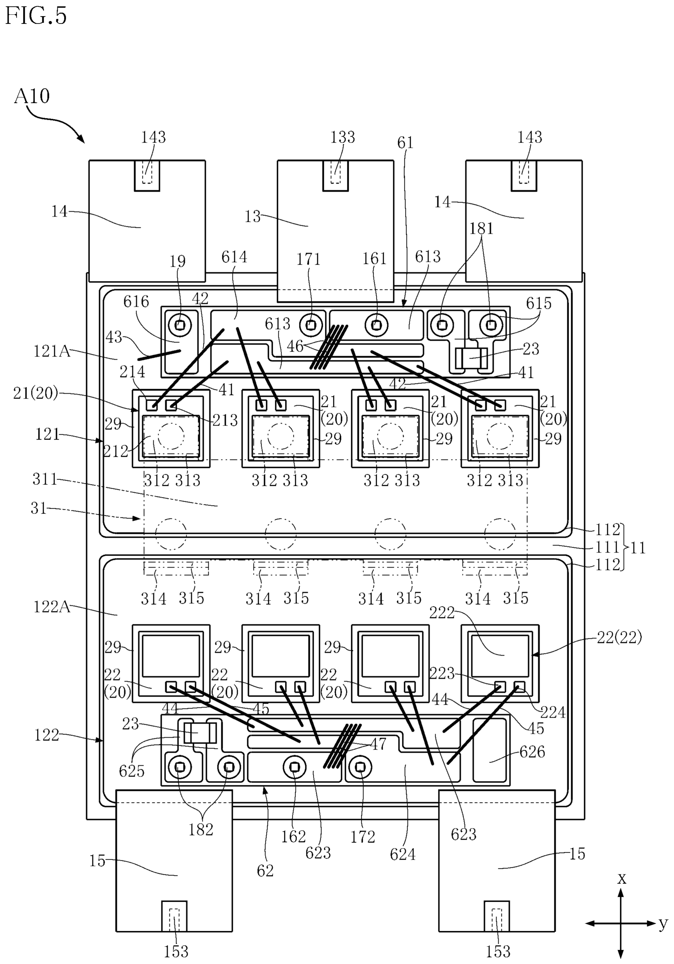

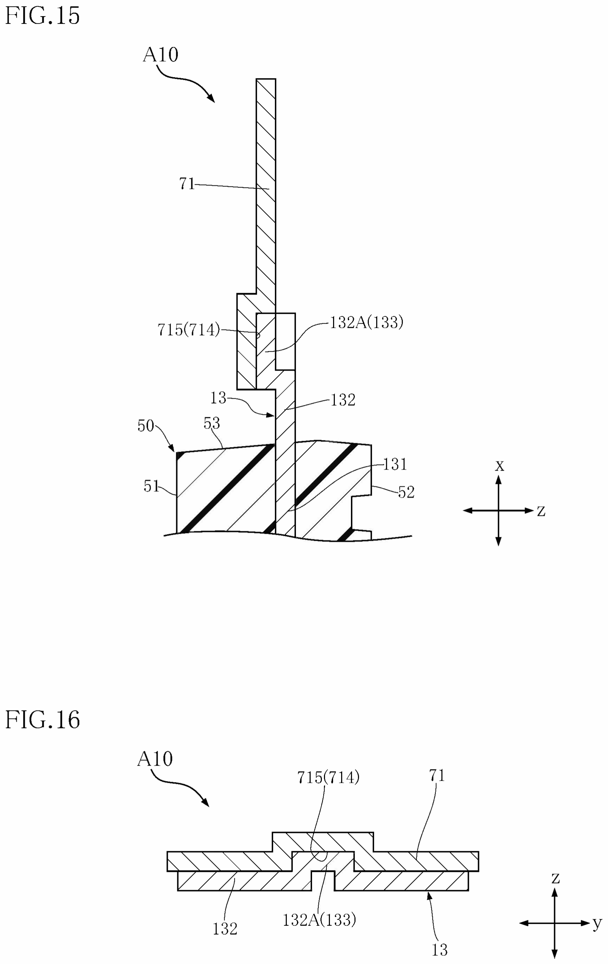

A semiconductor device A10 according to a first embodiment of the present disclosure will be described based on Figs. 1 to 16. The semiconductor device A10 is provided with a first conductive layer 121, a second conductive layer 122, a first power terminal 13, two second power terminals 14, two third power terminals 15, a plurality of semiconductor elements 20, a first conductive member 31, a second conductive member 32, a first sealing resin 50, a first extension terminal 71, two second extension terminals 72, and a third extension terminal 73. Furthermore, semiconductor device A10 is provided with a base material 11, a first signal terminal 161, a second signal terminal 162, a third signal terminal 171, a fourth signal terminal 172, two fifth signal terminals 181, two sixth signal terminals 182, a seventh signal terminal 191, two thermistors 23, a first wiring 61 and a second wiring 62. Here, in Figs. 3 and 4, the first sealing resin 50 is transparent for convenience of understanding. In Fig. 3, the transparent first sealing resin 50 is drawn with an imaginary line (a double-dotted line). In Fig. 5, for convenience of understanding, the first conductive member 31 is transparent, and the first extension terminal 71, the two second extension terminals 72, the third extension terminal 73, the first sealing resin 50, and the second conductive member 32 are omitted.

In the description of the semiconductor device A10, for convenience, the normal direction of the first main surface 121A of the first conductive layer 121, which will be described later, is referred to as a "first direction z". An example of a direction orthogonal to the first direction z is referred to as a "second direction x. The direction orthogonal to the first direction z and the second direction x is referred to as a "third direction y.

The semiconductor device A10 converts DC power input to the first power terminal 13 and the two second power terminals 14 into AC power by means of the plurality of semiconductor elements 20. The converted AC power is input from each of the two third power terminals 15 to a power supply target such as a motor.

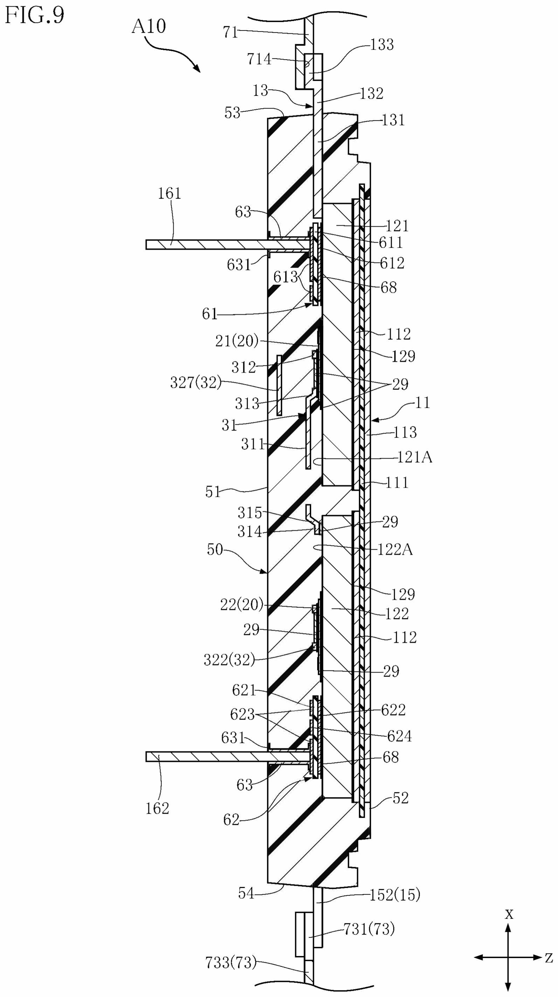

The base material 11 is located opposite the plurality of semiconductor elements 20 with respect to the first conductive layer 121 and the second conductive layer 122 in the first direction z, as shown in Figs. 9 to 11. The base material 11 supports the first conductive layer 121 and the second conductive layer 122. In the semiconductor device A10, the base material 11 comprises a DBC (Direct Bonded Copper) substrate. As shown in Figs. 9 to 11, the base material 11 includes an insulating layer 111, two intermediate layers 112, and a heat dissipation layer 113. The base material 11 is covered by the first sealing resin 50 except for a part of the heat dissipation layer 113.

As shown in Figs. 9 to 11, the insulating layer 111 includes a portion interposed between the intermediate layers 112 and the heat dissipation layer 113 in the first direction z. The insulating layer 111 is made of a material having relatively high thermal conductivity. The insulating layer 111 is made of, for example, a ceramic including aluminum nitride (AlN). In addition to ceramics, the insulating layer 111 may also be made of an insulating resin sheet. The dimension in the first direction z of the insulating layer 111 is smaller than the dimension in the first direction z of each of the first conductive layer 121 and the second conductive layer 122.

As shown in Figs. 9 to 11, the two intermediate layers 112 are located between the insulating layer 111, and the first conductive layer 121 and the second conductive layer 122 in the first direction z. The intermediate layers 112 are separated from each other in the second direction x. The composition of the intermediate layers 112 includes copper (Cu). As shown in Fig. 5, as viewed in the first direction z, the intermediate layers 112 are surrounded by a perimeter of the insulating layer 111.

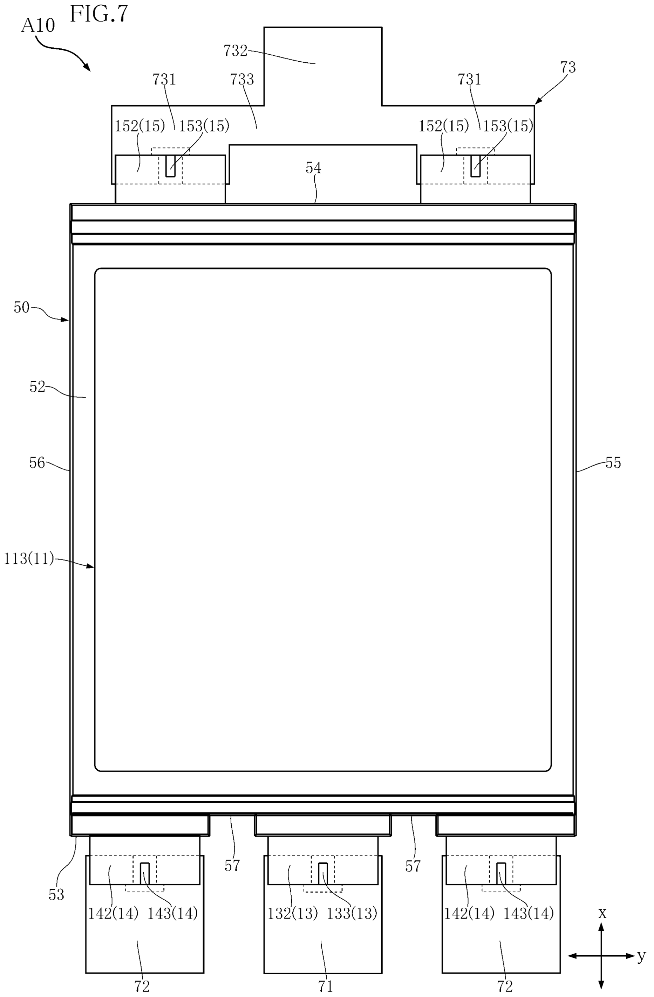

As shown in Figs. 9 to 11, the heat dissipation layer 113 is located opposite the two intermediate layers 112 with respect to the insulating layer 111 in the first direction z. As shown in Fig. 7, the heat dissipation layer 113 is exposed from the first sealing resin 50. The composition of the heat dissipation layer 113 includes copper. The dimension in the first direction z of the heat dissipation layer 113 is larger than the dimension in the first direction z of the insulating layer 111. As viewed in the first direction z, the heat dissipation layer 113 is surrounded by a perimeter of the insulating layer 111.

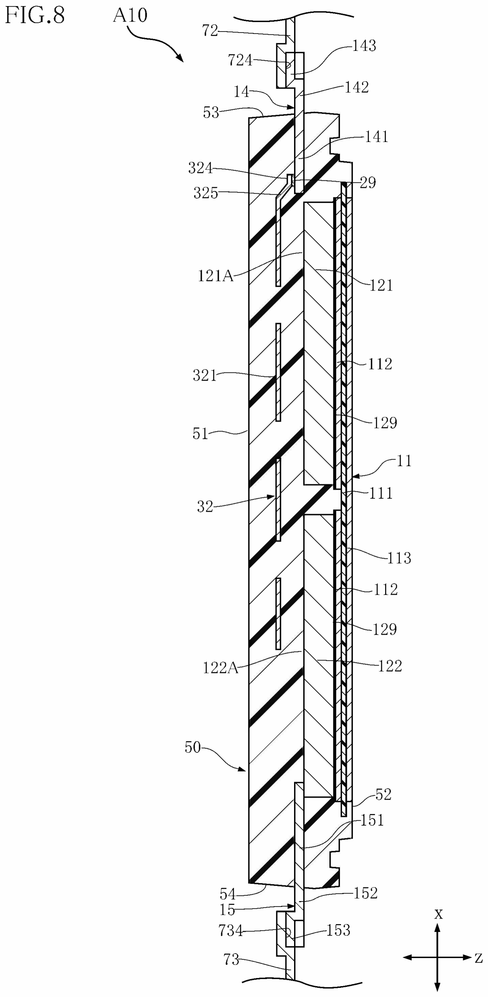

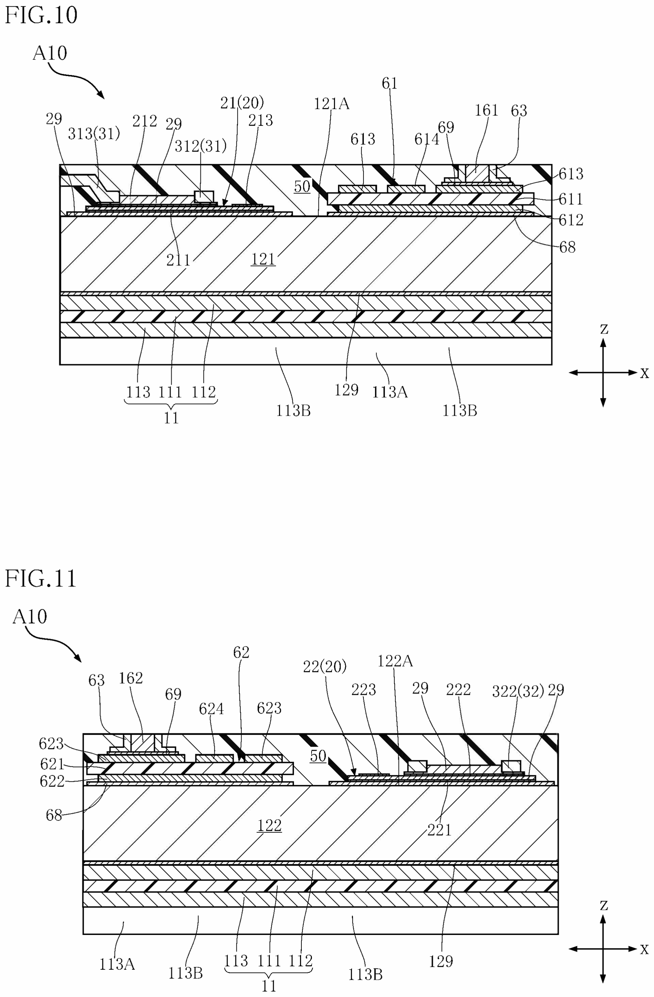

The first conductive layer 121 and the second conductive layer 122 are bonded to the base material 11 as shown in Figs. 9 to 11. The composition of the first conductive layer 121 and the second conductive layer 122 includes copper. The first conductive layer 121 and the second conductive layer 122 are separated from each other in the second direction x. As shown in Figs. 8 and 9, the first conductive layer 121 has a first main surface 121A facing the first direction z. The first main surface 121A faces the plurality of semiconductor elements 20. As shown in Fig. 10, the first conductive layer 121 is bonded to one of the two intermediate layers 112 via the first bonding layer 129. The first bonding layer 129 is, for example, solder. As shown in Figs. 8 and 9, the second conductive layer 122 has a second main surface 122A facing the same side as the first main surface 121A in the first direction z. As shown in Fig. 11, the second conductive layer 122 is bonded to the other of the two intermediate layers 112 via the first bonding layer 129.

Each of the plurality of semiconductor elements 20 is mounted on one of the first conductive layer 121 and the second conductive layer 122, as shown in Figs. 5 and 9. The plurality of semiconductor elements 20 are, for example, MOSFETs (Metal-Oxide-Semiconductor Field-Effect Transistors). In addition, the plurality of semiconductor elements 20 may be switching devices such as IGBTs (Insulated Gate Bipolar Transistors) and diodes. In the description of semiconductor device A10, the plurality of semiconductor elements 20 are n-channel MOSFETs with a vertical structure. The plurality of semiconductor elements 20 include a compound semiconductor substrate. The composition of the compound semiconductor substrate includes silicon carbide (SiC).

As shown in Fig. 5, in the semiconductor device A10, the plurality of semiconductor elements 20 include a plurality of first semiconductor elements 21 and a plurality of second semiconductor elements 22. The structure of each of the plurality of second semiconductor elements 22 is equal to the structure of each of the plurality of first semiconductor elements 21. The plurality of first semiconductor elements 21 are mounted on the first main surface 121A of the first conductive layer 121. The plurality of first semiconductor elements 21 are arranged along the third direction Y. The plurality of second semiconductor elements 22 are mounted on the second main surface 122A of the second conductive layer 122. The plurality of second semiconductor elements 22 are arranged along the third direction y.

As shown in Figs. 5 and 10, each of the plurality of first semiconductor elements 21 has a first electrode 211, a second electrode 212, a first gate electrode 213 and a first detection electrode 214.

As shown in Fig. 10, the first electrode 211 faces the first main surface 121A of the first conductive layer 121. A current corresponding to the electric power before being converted by the first semiconductor element 21 flows through the first electrode 211. In other words, the first electrode 211 corresponds to the drain electrode of the first semiconductor element 21. The first electrode 211 is conductively bonded to the first main surface 121A via the conductive bonding layer 29. As a result, the first electrode 211 of each of the plurality of first semiconductor elements 21 is conductive to the first conductive layer 121. The conductive bonding layer 29 is a sintered metal containing silver (Ag) or the like. In addition, the conductive bonding layer 29 may be solder.

As shown in Fig. 10, the second electrode 212 is located on the side opposite the side to face the first main surface 121A of the first conductive layer 121 in the first direction z. Thus, the first electrode 211 and the second electrode 212 are located on opposite sides of each other in the first direction z. A current corresponding to the electric power after being converted by the first semiconductor element 21 flows through the second electrode 212. In other words, the second electrode 212 corresponds to the source electrode of the first semiconductor element 21.

As shown in Fig. 10, the first gate electrode 213 is located on the side opposite the side to face the first main surface 121A of the first conductive layer 121 in the first direction z. Therefore, the first gate electrode 213 is located on the same side as the second electrode 212 in the first direction z. A gate voltage is applied to the first gate electrode 213 to drive the first semiconductor element 21. As shown in Fig. 5, the area of the first gate electrode 213 is smaller than the area of the second electrode 212 as viewed in the first direction z.

As shown in Fig. 5, the first detection electrode 214 is located on the same side as the second electrode 212 and the first gate electrode 213 in the first direction z. The first detection electrode 214 is located adjacent to the first gate electrode 213 in the third direction y. A voltage equivalent to the voltage applied to the second electrode 212 is applied to the first detection electrode 214. As viewed in the first direction z, the area of the first detection electrode 214 is substantially equal to the area of the first gate electrode 213.

As shown in Figs. 5 and 11, each of the plurality of second semiconductor elements 22 has a third electrode 221, a fourth electrode 222, a second gate electrode 223 and a second detection electrode 224.

As shown in Fig. 11, the third electrode 221 faces the second main surface 122A of the second conductive layer 122. A current corresponding to the electric power before being converted by the second semiconductor element 22 flows through the third electrode 221. In other words, the third electrode 221 corresponds to the drain electrode of the second semiconductor element 22. The third electrode 221 is conductively bonded to the second main surface 122A via the conductive bonding layer 29. As a result, the third electrode 221 of each of the plurality of second semiconductor elements 22 is conductive to the second conductive layer 122.

As shown in Fig. 11, the fourth electrode 222 is located on the side opposite the side to face the side the second main surface 122A of the second conductive layer 122 in the first direction z. Accordingly, the third electrode 221 and the fourth electrode 222 are located on opposite sides of each other in the first direction z. A current corresponding to the electric power after being converted by the second semiconductor element 22 flows through the fourth electrode 222. In other words, the fourth electrode 222 corresponds to the source electrode of the second semiconductor element 22.

As shown in Fig. 11, the second gate electrode 223 is located on the side opposite the side to face the second main surface 122A of the second conductive layer 122 in the first direction z. Therefore, the second gate electrode 223 is located on the same side as the fourth electrode 222 in the first direction z. A gate voltage is applied to the second gate electrode 223 to drive the second semiconductor element 22. As shown in Fig. 5, the area of the second gate electrode 223 is smaller than the area of the fourth electrode 222 as viewed in the first direction z.

As shown in Fig. 5, the second detection electrode 224 is located on the same side as the fourth electrode 222 and the second gate electrode 223 in the first direction z. Second detection electrodes 224 are located on both sides of the second gate electrode 223 in the third direction y. A voltage equivalent to the voltage applied to the fourth electrode 222 is applied to the second detection electrode 224. As viewed in the first direction z, the area of the second detection electrode 224 is substantially equal to the area of the second gate electrode 223.

The first power terminal 13 is located opposite the second conductive layer 122 with respect to the first conductive layer 121 in the second direction x, as shown in Figs. 3 and 9. The first power terminal 13 is conductively bonded to the first conductive layer 121. As a result, the first power terminal 13 is conductive to the first electrode 211 of each of the plurality of first semiconductor elements 21 via the first conductive layer 121. The first power terminal 13 is a P terminal (positive pole) to which DC power to be converted is input. The first power terminal 13 extends from the first conductive layer 121 in the second direction x. The first power terminal 13 has a first covered portion 131 and a first exposed portion 132. As shown in Fig. 9, the first covered portion 131 is conductively bonded to the first conductive layer 121 and is covered by the first sealing resin 50. The first covered portion 131 is flush with the first main surface 121A of the first conductive layer 121. The first exposed portion 132 extends from the first covered portion 131 in the second direction x and is exposed externally from the first sealing resin 50.

Each of the two second power terminals 14 is located on the same side as the first power terminal 13 with respect to the first conductive layer 121 and the second conductive layer 122 in the second direction x and is separated from the first conductive layer 121 and the second conductive layer 122, as shown in Figs. 3 and 8. Each of the two second power terminals 14 is conductive to the fourth electrode 222 of each of the plurality of second semiconductor elements 22 The two second power terminals are N terminals (negative poles) to which DC power to be converted is input. The second power terminals 14 are separated from each other in the third direction y. Between the two second power terminals 14 in the third direction y, the first power terminal 13 is located. Each of the two second power terminals 14 has a second covered portion 141 and a second exposed portion 142. As shown in Fig. 8, the second covered portion 141 is separated from the first conductive layer 121 and is covered by the first sealing resin 50. The second exposed portion 142 extends from the second covered portion 141 in the second direction x and is exposed externally from the first sealing resin 50.

Each of the two third power terminals 15 is located opposite the first conductive layer 121 with respect to the second conductive layer 122 in the second direction x, as shown in Figs. 3 and 8. Each of the two third power terminals 15 is conductively bonded to the second conductive layer 122. As a result, each of the two third power terminals 15 is conductive to the third electrode 221 of each of the plurality of second semiconductor elements 22 via the second conductive layer 122. AC power converted by the plurality of semiconductor elements 20 is output from each of the two third power terminals 15. In the semiconductor device A10, the two third power terminals 15 are separated from each other in the third direction y. Each of the two third power terminals 15 has a third covered portion 151 and a third exposed portion 152. As shown in Fig. 8, the third covered portion 151 is conductively bonded to the second conductive layer 122 and is covered by the first sealing resin 50. The third covered portion 151 is flush with the second main surface 122A of the second conductive layer 122. The third exposed portion 152 extends from the third covered portion 151 in the second direction x and is exposed externally from the first sealing resin 50.

The first wiring 61 is bonded to the first main surface 121A of the first conductive layer 121 as shown in Fig. 10. The first wiring 61 is located opposite to the plurality of second semiconductor elements 22 with respect to the plurality of first semiconductor elements 21 in the second direction x. The first wiring 61 is conductive to the plurality of first semiconductor elements 21 and the first conductive layer 121. As shown in Figs. 5 and 10, the first wiring 61 has a first mounting layer 611, a first metal layer 612, two first gate wiring layers 613, a first detection wiring layer 614, a first temperature detection wiring layer 615 and a second detection wiring layer 616.

As shown in Fig. 5, the first mounting layer 611 carries two first gate wiring layers 613, a first detection wiring layer 614, two first temperature detection wiring layers 615, and a second detection wiring layer 616. The first mounting layer 611 is an insulator. The first mounting layer 611 is made of ceramics, for example. In addition, the first mounting layer 611 may also be made of an insulating resin sheet.

As shown in Fig. 10, the first metal layer 612 is located on the side opposite the first main surface 121A of the first conductive layer 121 with respect to the first mounting layer 611 in the first direction z. The first metal layer 612 is bonded to the first mounting layer 611. The composition of the first metal layer 612 includes copper. The first metal layer 612 is bonded to the first main surface 121A via the second bonding layer 68. The second bonding layer 68 is, for example, solder.

As shown in Figs. 5 and 10, the two first gate wiring layers 613 are located opposite the first metal layer 612 with respect to the first mounting layer 611. The two first gate wiring layers 613 are bonded to the first mounting layer 611. A plurality of first wires 41 are conductively bonded to one of the two first gate wiring layers 613. The plurality of first wires 41 are conductively bonded to the first gate electrode 213 of each of the plurality of first semiconductor elements 21 individually. Further, a plurality of sixth wires 46 are conductively bonded to each of the two first gate wiring layers 613. As a result, each of the two first gate wiring layers 613 is conductive to the first gate electrode 213 of each of the plurality of first semiconductor elements 21.

As shown in Figs. 5 and 10, the first detection wiring layer 614 is located opposite the first metal layer 612 with respect to the first mounting layer 611. The first detection wiring layer 614 is bonded to the first mounting layer 611. A plurality of second wires 42 are conductively bonded to the first detection wiring layer 614. Further, the plurality of second wires 42 are conductively bonded individually to the first detection electrode 214 of each of the plurality of first semiconductor elements 21. As a result, the first detection wiring layer 614 is conductive to the first detection electrode 214 of each of the plurality of first semiconductor elements 21.

As shown in Fig. 5, the two first temperature detection wiring layers 615 are located opposite the first metal layer 612 with respect to the first mounting layer 611. The two first temperature detection wiring layers 615 are bonded to the first mounting layer 611. The two first temperature detection wiring layers 615 are adjacent to each other in the third direction y.

As shown in Fig. 5, the second detection wiring layer 616 is located opposite the first metal layer 612 with respect to the first mounting layer 611. The second detection wiring layer 616 is bonded to the first mounting layer 611. A third wire 43 is conductively bonded to the second detection wiring layer 616. Further, the third wire 43 is conductively bonded to the first main surface 121A of the first conductive layer 121. As a result, the second detection wiring layer 616 is conductive to the first conductive layer 121.

The second wiring 62 is bonded to the second main surface 122A of the second conductive layer 122, as shown in Fig. 11. The second wiring 62 is located opposite the plurality of first semiconductor elements 21 with respect to the plurality of second semiconductor elements 22 in the second direction x. The second wiring 62 is conductive to the plurality of second semiconductor elements 22 and the second conductive layer 122. As shown in Figs. 5 and 11, the second wiring 62 has a second mounting layer 621, a second metal layer 622, two second gate wiring layers 623, a third detection wiring layer 624, two second temperature detection wiring layers 625, and a fourth detection wiring layer 626.

As shown in Fig. 5, the second mounting layer 621 carries two second gate wiring layers 623, a third detection wiring layer 624, two second temperature detection wiring layers 625, and a fourth detection wiring layer 626. The second mounting layer 621 is an insulator. The second mounting layer 621 is made of ceramics, for example. In addition, the second mounting layer 621 may also be made of an insulating resin sheet.

As shown in Fig. 11, the second metal layer 622 is located on the side opposite the second main surface 122A of the second conductive layer 122 with respect to the second mounting layer 621 in the first direction z. The second metal layer 622 is bonded to the second mounting layer 621. The composition of the second metal layer 622 includes copper. The second metal layer 622 is bonded to the second main surface 122A via the second bonding layer 68.

As shown in Figs. 5 and 11, the two second gate wiring layers 623 are located opposite the second metal layer 622 with respect to the second mounting layer 621. The two second gate wiring layers 623 are bonded to the second mounting layer 621. A plurality of fourth wires 44 are conductively bonded to one of the two second gate wiring layers 623. The plurality of fourth wires 44 are conductively bonded to the second gate electrode 223 of each of the plurality of second semiconductor elements 22 individually. Further, a plurality of seventh wires 47 are conductively bonded to each of the two second gate wiring layers 623. As a result, each of the two second gate wiring layers 623 is conductive to the second gate electrode 223 of each of the plurality of second semiconductor elements 22.

As shown in Figs. 5 and 11, the third detection wiring layer 624 is located opposite the second metal layer 622 with respect to the second mounting layer 621. The third detection wiring layer 624 is bonded to the second mounting layer 621. A plurality of fifth wires 45 are conductively bonded to the third detection wiring layer 624. Further, the plurality of fifth wires 45 are conductively bonded individually to the second detection electrode 224 of each of the plurality of second semiconductor elements 22. As a result, the third detection wiring layer 624 is conductive to the second detection electrode 224 of each of the plurality of second semiconductor elements 22.

As shown in Fig. 5, the two second temperature detection wiring layers 625 are located opposite the second metal layer 622 with respect to the second mounting layer 621. The two second temperature detection wiring layers 625 are bonded to the second mounting layer 621. The two second temperature detection wiring layers 625 are adjacent to each other in the third direction y.

As shown in Fig. 5, the fourth detection wiring layer 626 is located opposite the second metal layer 622 with respect to the second mounting layer 621. The fourth detection wiring layer 626 is bonded to the second mounting layer 621.

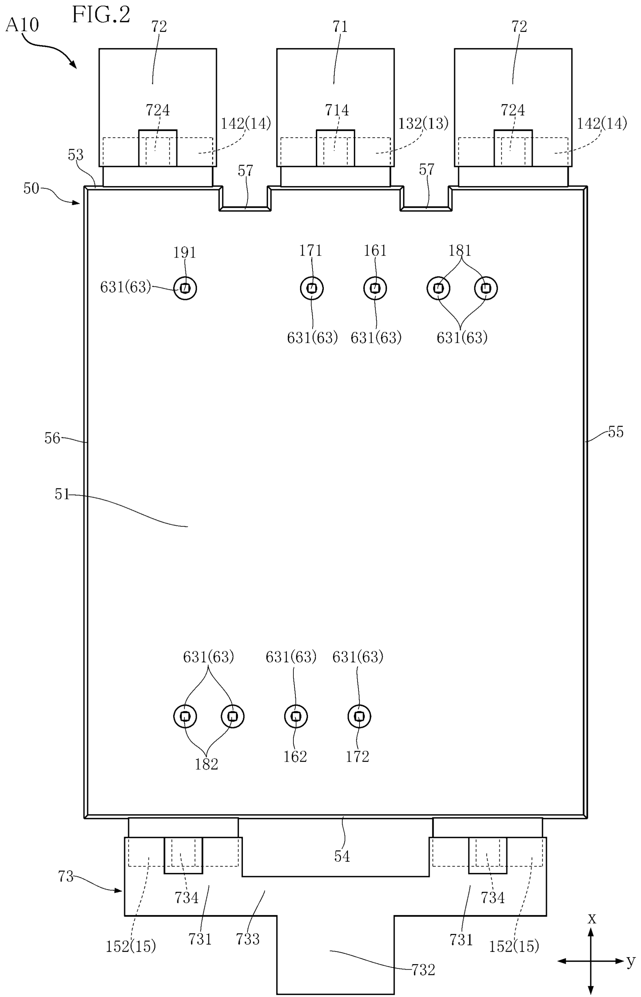

As shown in Figs. 10 and 11, each of the plurality of sleeves 63 is conductively bonded to one of the first wiring 61 and the second wiring 62 via the third bonding layer 69. The third bonding layer 69 is, for example, solder. The plurality of sleeves 63 are made of conductive material such as metal. Each of the plurality of sleeves 63 is cylindrical to extend in the first direction z. As shown in Figs. 2 and 9, each of the plurality of sleeves 63 has an end surface 631 facing the same side as the first main surface 121A of the first conductive layer 121 in the first direction z. The end surface 631 is exposed externally from the top surface 51 of the first sealing resin 50 to be described later. The third bonding layer 69 is, for example, solder.

One of the two thermistors 23 is conductively bonded to the two first temperature detection wiring layers 615 of the first wiring 61, as shown in Fig. 4. The other one of the two thermistors 23 is conductively bonded the two second temperature detection wiring layers 625 of the second wiring 62, as shown in Fig. 4. The two thermistors 23 are used as sensors for temperature detection of the semiconductor device A10.

The first signal terminal 161, the second signal terminal 162, the third signal terminal 171, the fourth signal terminal 172, the two fifth signal terminals 181, the two sixth signal terminals 182, and the seventh signal terminal 191 are composed of metal pins extending in the first direction z as shown in Fig. 1. These terminals protrude from the top surface 51 of the first sealing resin 50, to be described later. Furthermore, these terminals are individually press-fitted into the plurality of sleeves 63. As a result, each of these terminals is supported by one of the plurality of sleeves 63 and is conductive to one of the first wiring 61 and the second wiring 62.

The first signal terminal 161 is press-fitted into a sleeve 63 that is conductively bonded to one of the two first gate wiring layers 613 of the first wiring 61 out of the plurality of sleeves 63, as shown in Figs. 5 and 10. As a result, the first signal terminal 161 is conductive to the first gate electrode 213 of each of the plurality of first semiconductor elements 21 via the two first gate wiring layers 613. A gate voltage is applied to the first signal terminal 161 to drive the plurality of first semiconductor elements 21.

The second signal terminal 162 is press-fitted into a sleeve 63 that is conductively bonded to one of the two second gate wiring layers 623 of the second wiring 62 out of the plurality of sleeves 63, as shown in Figs. 5 and 11. As a result, the second signal terminal 162 is conductive to the second gate electrode 223 of each of the plurality of second semiconductor elements 22 via the two second gate wiring layers 623. A gate voltage is applied to the second signal terminal 162 to drive the plurality of second semiconductor elements 22.

The third signal terminal 171 is located adjacent to the first signal terminal 161 in the third direction y, as shown in Fig. 2. As shown in Fig. 5, the third signal terminal 171 is press-fitted into a sleeve 63 that is conductively bonded to the first detection wiring layer 614 of the first wiring 61 out of the plurality of sleeves 63. As a result, the third signal terminal 171 is conductive to the first detection electrode 214 of each of the plurality of first semiconductor elements 21 via the first detection wiring layer 614. A voltage equivalent to the voltage applied to the first detection electrode 214 of each of the plurality of first semiconductor elements 21 is applied to the third signal terminal 171.

The fourth signal terminal 172 is located adjacent to the second signal terminal 162 in the third direction y, as shown in Fig. 2. The fourth signal terminal 172 is press-fitted into a sleeve 63 that is conductively bonded to the third detection wiring layer 624 of the second wiring 62 out of the plurality of sleeves 63, as shown in Fig. 5. As a result, the fourth signal terminal 172 is conductive to the second detection electrode 224 of each of the plurality of second semiconductor elements 22 via the third detection wiring layer 624. A voltage equivalent to the voltage applied to the second detection electrode 224 of each of the plurality of second semiconductor elements 22 is applied to the fourth signal terminal 172.

The two fifth signal terminals 181 are located opposite the third signal terminal 171 with respect to the first signal terminal 161 in the third direction y, as shown in Fig. 2. The two fifth signal terminals 181 are adjacent to each other in the third direction y. As shown in Fig. 5, the two fifth signal terminals 181 are individually press-fitted into two sleeves 63 which are individually conductively bonded to the two first temperature detection wiring layers 615 of the first wiring 61, out of the plurality of sleeves 63. As a result, the two fifth signal terminals 181 are conductive to a thermistor 23 conductively bonded to the two first temperature detection wiring layers 615 out of the two thermistors 23.

The two sixth signal terminals 182 are located opposite the fourth signal terminal 172 with respect to the second signal terminal 162 in the third direction y, as shown in FIG. 2. The two sixth signal terminals 182 are adjacent to each other in the third direction y. As shown in Fig. 5, the two sixth signal terminals 182 are individually press-fitted into two of the plurality of sleeves 63 that are individually conductively bonded to the two second temperature detection wiring layers 625 of the second wiring 62. As a result, the two sixth signal terminals 182 are conductive to a thermistor 23 conductively bonded to the two second temperature detection wiring layers 625, out of the two thermistors 23.

The seventh signal terminal 191 is located opposite the first signal terminal 161 with respect to the third signal terminal 171 in the third direction y, as shown in Fig. 2. As shown in Fig. 5, the seventh signal terminal 191 is press-fitted into a sleeve 63 conductively bonded to the second detection wiring layer 616 of the first wiring 61, out of the plurality of sleeves 63. As a result, the seventh signal terminal 191 is conductive to the first conductive layer 121 via the second detection wiring layer 616. A voltage equivalent to the DC power input to the first power terminal 13 and the two second power terminals 14 is applied to the seventh signal terminal 191.

The first conductive member 31 is conductively bonded to the second electrode 212 of the plurality of first semiconductor elements 21 and the second main surface 122A of the second conductive layer 122, as shown in Figs. 5 and 10. As a result, the second electrodes 212 of the plurality of first semiconductor elements 21 are conductive to the second conductive layer 122. The composition of the first conductive member 31 includes copper. The first conductive member 31 is a metal clip. As shown in Fig. 5, the first conductive member 31 has a body portion 311, a plurality of first bonding portions 312, a plurality of first coupling portions 313, a second bonding portion 314, and a second coupling portion 315.

The body portion 311 is the main part of the first conductive member 31. As shown in Fig. 5, the body portion 311 extends in the third direction y. As shown in Fig. 9, the body portion 311 straddles an area between the first conductive layer 121 and the second conductive layer 122.

As shown in Fig. 10, the plurality of first bonding portions 312 are individually bonded to the second electrodes 212 of the plurality of first semiconductor elements 21. Each of the plurality of first bonding portions 312 faces the second electrode 212 of one of the plurality of first semiconductor elements 21.

As shown in Fig. 5, the plurality of first coupling portions 313 are connected to the body portion 311 and the plurality of first bonding portions 312. The plurality of first coupling portions 313 are separated from each other in the third direction y. As shown in Fig. 9, as viewed in the third direction y, the plurality of first coupling portions 313 are inclined in a manner to get away from the first main surface 121A of the first conductive layer 121 as they are separated from the plurality of first bonding portions 312 and gets closer to the body portion 311.

As shown in Figs. 5 and 9, the second bonding portion 314 is bonded to the second main surface 122A of the second conductive layer 122. The second bonding portion 314 faces the second main surface 122A. The second bonding portion 314 extends in the third direction y. The dimension of the second bonding portion 314 in the third direction y is equal to the dimension of the body portion 311 in the third direction y.

As shown in Figs. 5 and 9, the second coupling portion 315 is connected to the body portion 311 and the second bonding portion 314. As viewed in the third direction y, the second coupling portion 315 is inclined in a manner to get away from the second main surface 122A of the second conductive layer 122 as it is separated from the second bonding portion 314 and gets closer to the body portion 311. The dimension of the second coupling portion 315 in the third direction y is equal to the dimension of the body portion 311 in the third direction y.

As shown in Figs. 9, 10 and 13, the conductive bonding layer 29 is located between the second electrode 212 of each of the plurality of first semiconductor elements 21 and each of the plurality of first bonding portions 312. The conductive bonding layer 29 conductively bonds each of the plurality of first bonding portions 312 and the second electrode 212 of each of the plurality of first semiconductor elements 21 individually. As shown in Fig. 9, the conductive bonding layer 29 is located between the second main surface 122A of the second conductive layer 122 and the second bonding portion 314. The conductive bonding layer 29 conductively bonds the second main surface 122A and the second bonding portion 314.

The second conductive member 32 is conductively bonded to the second electrodes 212 of the plurality of second semiconductor elements 22 and the second covered portions 141 of the second power terminals 14, as shown in Figs. 4 and 11. As a result, the second electrodes 212 of the plurality of second semiconductor elements 22 are conductive to the second power terminals 14. The composition of the second conductive member 32 includes copper. The second conductive member 32 is a metal clip. As shown in Fig. 4, the second conductive member 32 has two body portions 321, a plurality of third bonding portions 322, a plurality of third coupling portions 323, two fourth bonding portions 324, two fourth coupling portions 325, a plurality of intermediate portions 326, and a plurality of transverse beam portions 327.

As shown in Fig. 4, the two body portions 321 are separated from each other in the third direction y. The two body portions extend in the second direction x. As shown in Fig. 8, the two body portions 321 are arranged parallel to the first main surface 121A of the first conductive layer 121 and the second main surface 122A of the second conductive layer 122. The two body portions 321 are separated from the first main surface 121A and the second main surface 122A more than the body portion 311 of the first conductive member 31 is.

As shown in Fig. 4, the plurality of intermediate portions 326 are separated from each other in the third direction y and are located between the two body portions 321 in the third direction y. The plurality of intermediate portions 326 extend in the second direction x. The dimension in the second direction x of each of the plurality of intermediate portions 326 is smaller than the dimension in the second direction x of each of the two body portions 321.

As shown in Fig. 11, the plurality of third bonding portions 322 are individually bonded to the second electrodes 212 of the plurality of second semiconductor elements 22. Each of the plurality of third bonding portions 322 faces the fourth electrode 222 of one of the plurality of second semiconductor elements 22.

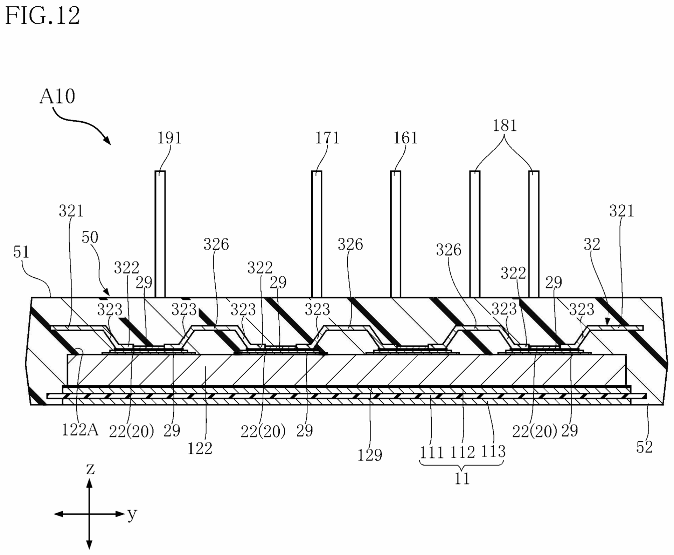

As shown in Figs. 4 and 12, the plurality of third coupling portions 323 are connected to both sides of the plurality of third bonding portions 322 in the third direction y. Further, the plurality of third coupling portion 323 are connected to one of the two body portions 321 and the plurality of intermediate portions 326. As viewed in the second direction x, each of the plurality of third coupling portions 323 is inclined in a manner to get away from the second main surface 122A of the second conductive layer 122 as it is separated from one of the plurality of third bonding portions 322 and gets closer to one of the two body portions 321 and the plurality of intermediate portions 326.

As shown in Figs. 4 and 8, the two fourth bonding portions 324 are individually bonded to the second covered portions 141 of the two second power terminals 14. Each of the two fourth bonding portions 324 faces the second covered portion 141.

As shown in Figs. 4 and 8, the two fourth coupling portions 325 are connected to the two body portions 321 and the two fourth bonding portions 324. As viewed in the third direction y, the two fourth coupling portions 325 are inclined in a manner to get away from the first main surface 121A of the first conductive layer 121 as they are separated from the two fourth bonding portions 324 and get closer to the two body portions 321.

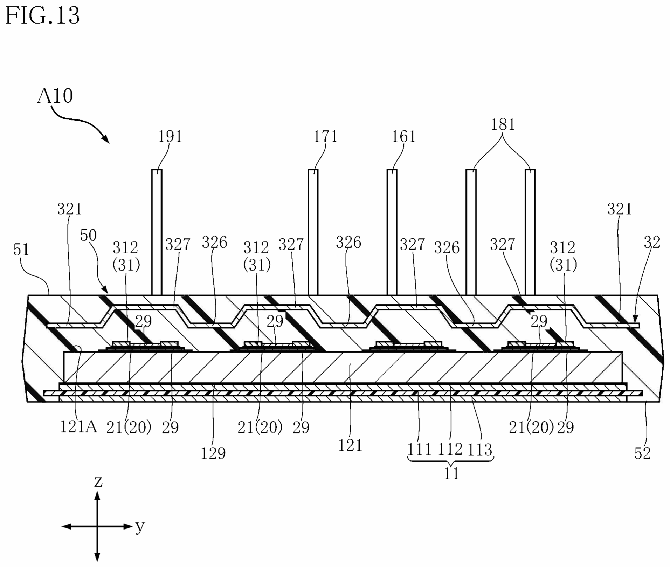

As shown in Figs. 4 and 13, the plurality of transverse beam portions 327 are arranged along the third direction y. As viewed in the first direction z, the plurality of transverse beam portions 327 include regions individually overlapping the plurality of first bonding portions 312 of the first conductive member 31. Both sides in the third direction y of a transverse beam portions 327 that are in the middle in the third direction y from among the plurality of transverse beam portions are connected to the plurality of intermediate portions 326. Both sides in the third direction y of the remaining two transverse beam portions 327 out of the plurality of transverse beam portions 327 are connected to one of the two body portions 321 and one of the plurality of intermediate portions 326. As viewed in the second direction x, the plurality of transverse beam portions 327 are convex in the first direction z toward the side toward which the first main surface 121A of the first conductive layer 121 faces.

As shown in Figs. 9, 11 and 12, a conductive bonding layer 29 is located between the fourth electrode 222 of each of the plurality of second semiconductor elements 22 and each of the plurality of third bonding portions 322. The conductive bonding layer 29 conductively bonds each of the plurality of third bonding portions 322 and the fourth electrode 222 of each of the plurality of second semiconductor elements 22 individually. As shown in Fig. 8, the conductive bonding layer 29 is located between the second covered portion 141 of each of the two second power terminals 14 and the two fourth bonding portions 324. The conductive bonding layer 29 conductively bonds the second covered portion 141 of each of the two second power terminals 14 and the two fourth bonding portions 324 individually.

The first sealing resin 50 covers the first conductive layer 121, the second conductive layer 122, the plurality of semiconductor elements 20, the first conductive member 31 and the second conductive member 32 as shown in Figs. 8, 9, 12 and 13. Further, the first sealing resin 50 covers a part of each of the base material 11, the first power terminal 13, the third power terminal 15, and the second power terminal 14. The first sealing resin 50 has electrical insulating properties. The first sealing resin 50 is made of a material including, for example, a black epoxy resin. As shown in Fig. 2 and Figs. 6 to 9, the first sealing resin 50 has a top surface 51, a bottom surface 52, a first side surface 53, a second side surface 54, a third side surface 55, a fourth side surface 56, and two concave portions 57.

As shown in Figs. 8 and 9, the top surface 51 faces the same side as the first main surface 121A of the first conductive layer 121 in the first direction z. As shown in Figs. 8 and 9, the bottom surface 52 faces the side opposite to the side the top surface 51 faces in the first direction z. As shown in Fig. 7, the heat dissipation layer 113 of the base material 11 is exposed from the bottom surface 52.

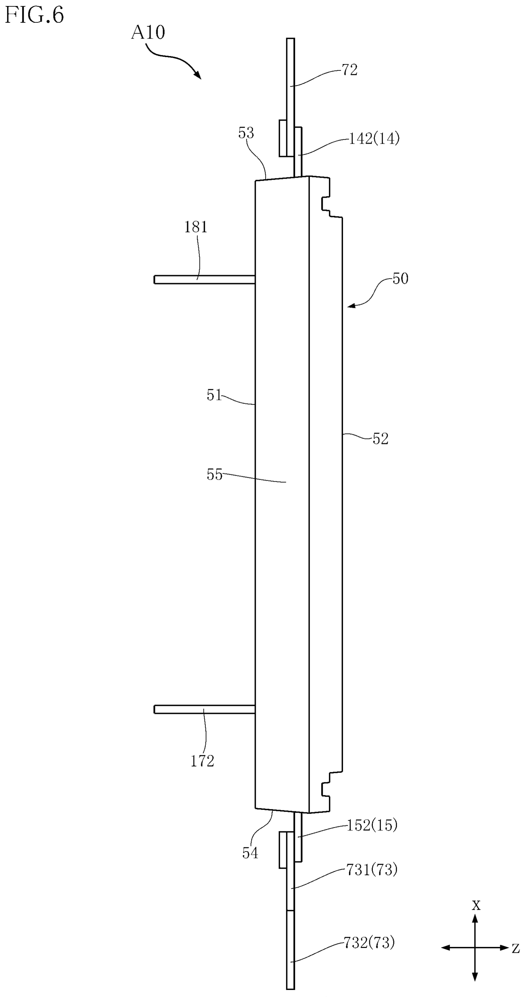

As shown in Figs. 2 and 6, the first side surface 53 and the second side surface 54 are separated from each other in the second direction x. The first side surface 53 and the second side surface 54 face opposite each other in the second direction x. From the first side surface 53, the first exposed portion 132 of the first power terminal 13 and the second exposed portion 142 of each of the two second power terminals 14 are exposed to the outside. From the second side surface 54, the third exposed portion 152 of each of the two third power terminals 15 is exposed to the outside.

As shown in Figs. 2 and 7, the third side surface 55 and the fourth side surface 56 are separated from each other in the third direction y. The third side surface 55 and the fourth side surface 56 face directions opposite each other in the third direction y.

As shown in Figs. 2 and 7, the two concave portions 57 are recessed from the first side surface 53 toward the second direction x. The two concave portions 57 are ranging from the top surface 51 to the bottom surface 52 in the first direction z. The two concave portions 57 are located on both sides in the third direction y of the first power terminal 13.

Next, the first extension terminal 71, the two second extension terminals 72, and the third extension terminal 73 provided with the semiconductor device A10 will be described.

As shown in Figs. 2, 3 and 7, the first extension terminal 71 is conductively bonded to the first exposed portion 132 of the first power terminal 13. The first extension terminal 71 extends in the second direction x. Here, the first exposed portion 132 of the first power terminal 13 is provided with a first engagement portion 133. The second engagement portion 714 is provided on the first extension terminal 71. As shown in Fig. 9, the second engagement portion 714 is in contact with the first engagement portion 133. The first engagement portion 133 and the second engagement portion 714 are means for positioning the first extension terminal 71 with respect to the first exposed portion 132.

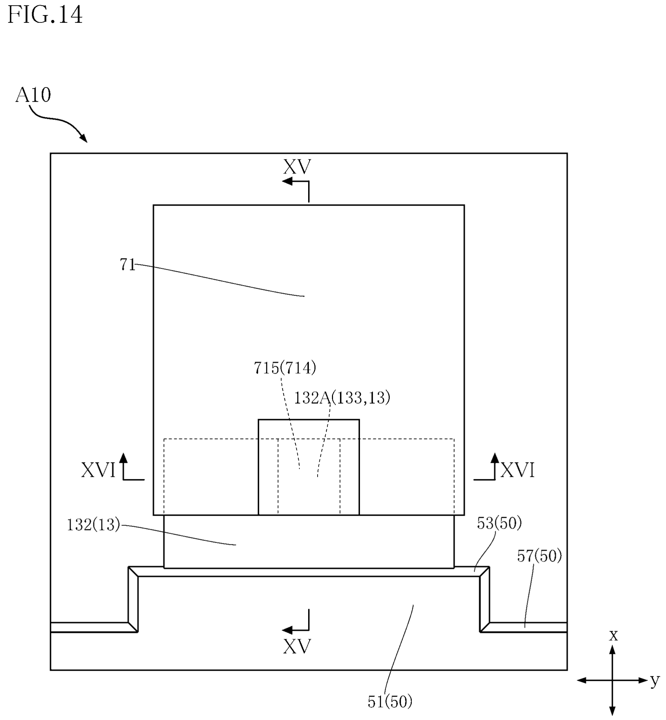

As shown in Figs. 14 to 16, a convex portion 132A is provided on the first exposed portion 132 of the first power terminal 13. The convex portion 132A protrudes toward one side in the first direction z. A concave portion 715 is provided on the first extension terminal 71. The concave portion 715 is recessed toward the side toward which the convex portion 132A protrudes in the first direction z. The convex portion 132A is fitted into the concave portion 715. The first engagement portion 133 of the first power terminal 13 includes the convex portion 132A. The second engagement portion 714 of the first extension terminal 71 includes the concave portion 715.

As shown in Figs. 2, 3 and 7, the two second extension terminals 72 are individually conductively bonded to the second exposed portions 142 of each of the two second power terminals 14. Each of the two second extension terminals 72 extends in the second direction x. Here, a third engagement portion 143 is provided at the second exposed portion 142 of each of the two second power terminals 14. The configuration of the third engagement portion 143 is equivalent to the configuration of the first engagement portion 133 of the first power terminal 13. Each of the two second extension terminals 72 is provided with a fourth engagement portion 724. The configuration of the fourth engagement portion 724 is equivalent to the configuration of the second engagement portion 714 of the first extension terminal 71. As shown in Fig. 8, the fourth engagement portion 724 is in contact with the third engagement portion 143. The Third engagement portion 143 and the fourth engagement portion 724 are means for positioning one of the two second extension terminals 72 with respect to the second exposed portion 142.

As shown in Figs. 2, 3 and 7, the third extension terminal 73 is conductively bonded to the third exposed portion 152 of each of the two third power terminals 15. The third extension terminal 73 has two internal connecting portions 731, an external connecting portion 732, and a coupling portion 733. The two internal connecting portions 731 are individually conductively bonded to the third exposed portion 152 of each of the two third power terminals 15. The external connecting portion 732 is located opposite the two internal connecting portions 731 with respect to the coupling portion 733. The coupling portion 733 connects the two internal connecting portions 731 and the external connecting portion 732.

As shown in Fig. 7, a fifth engagement portion 153 is provided at the third exposed portion 152 of each of the two third power terminals 15. The configuration of the fifth engagement portion 153 is equivalent to the configuration of the first engagement portion 133 of the first power terminal 13. A sixth engagement portion 734 is provided at each of the two internal connecting portions 731 of the third extension terminal 73. The configuration of the sixth engagement portion 734 is equivalent to the configuration of the second engagement portion 714 of the first extension terminal 71. As shown in Fig. 8, the sixth engagement portion 734 is in contact with the fifth engagement portion 153. The fifth engagement portion 153 and the sixth engagement portion 734 are means for positioning the third extension terminal 73 with respect to the third exposed portion 152.

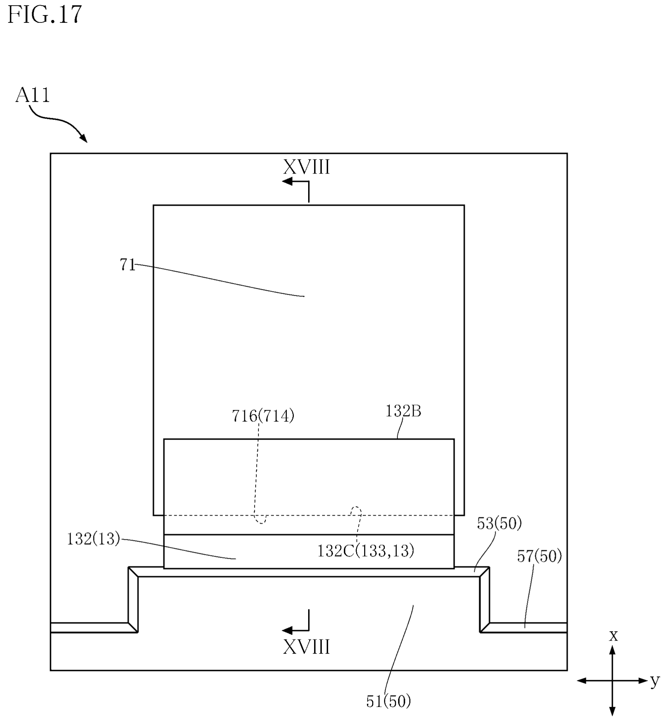

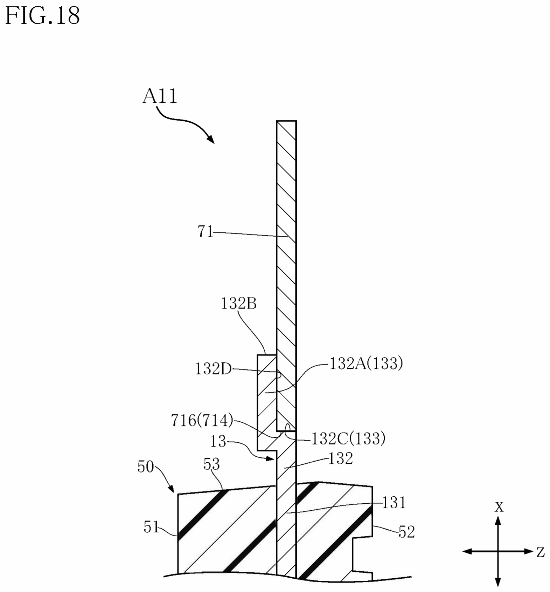

Next, a semiconductor device A11 according to a first variation of the first embodiment of the present disclosure will be described based on Figs. 17 and 18. Fig. 17 corresponds to Fig. 14, which shows semiconductor device A10. In the semiconductor device A11, the configuration of the first engagement portion 133 of the first power terminal 13 and the second engagement portion 714 of the first extension terminal 71 is different from that of the semiconductor device A10.

As shown in Fig. 18, the first exposed portion 132 of the first power terminal 13 has an end surface 132B, a first butt surface 132C, and an intermediate surface 132D. The end surface 132B faces the side opposite the side on which the first side surface 53 of the first sealing resin 50 is located in the second direction x. The first butt surface 132C faces the same side as the end surface 132B in the second direction x. The first butt surface 132C is located between the end surface 132B and the first side surface 53 in the second direction x. The intermediate surface 132D is located between the end surface 132B and the first butt surface 132C in the first direction z. As viewed in the first direction z, the intermediate surface 132D overlaps the first extension terminal 71. The intermediate surface 132D faces the first extension terminal 71.

As shown in Figs. 17 and 18, the first extension terminal 71 has a second butt surface 716. The second butt surface 716 faces the first butt surface 132C of the first exposed portion 132 of the first power terminal 13. The first extension terminal 71 is in contact with the intermediate surface 132D of the first exposed portion 132 of the first power terminal 13.

In the semiconductor device A11, the first engagement portion 133 of the first power terminal 13 includes the first butt surface 132C. The second engagement portion 714 of the first extension terminal 71 includes a second butt surface 716.

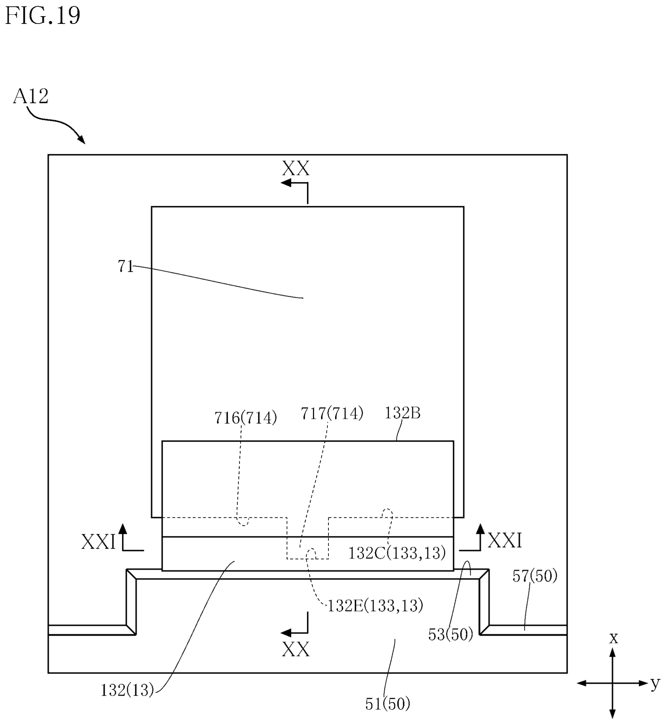

Next, a semiconductor device A12 according to a second variation of the first embodiment of the present disclosure will be described based on Figs. 19 to 21. Fig. 19 corresponds to Fig. 14, which shows semiconductor device A10. In the semiconductor device A12, the configuration of the first engagement portion 133 of the first power terminal 13 and the second engagement portion 714 of the first extension terminal 71 is different from that of the semiconductor device A10.

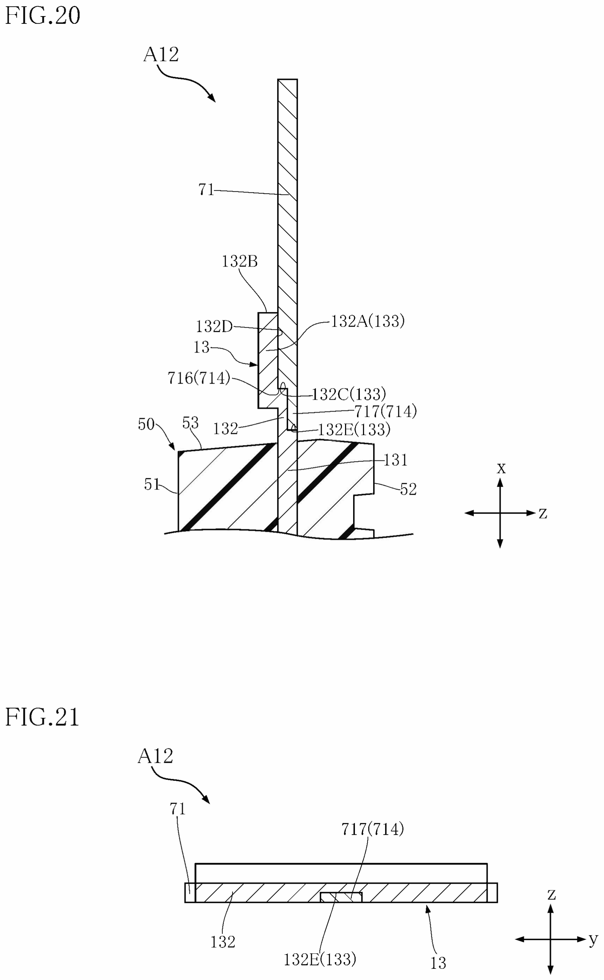

As shown in Fig. 20, the first exposed portion 132 of the first power terminal 13 has the end surface 132B, the first butt surface 132C, the intermediate surface 132D, and an auxiliary concave portion 132E. The auxiliary concave portion 132E is recessed from the first butt surface 132C. As shown in Figs. 19 and 20, the first extension terminal 71 has the second butt surface 716 and an auxiliary convex portion 717. The auxiliary convex portion 717 protrudes from the second butt surface 716. As shown in Fig. 20, the auxiliary convex portion 717 is fitted into the auxiliary concave portion 132E.

In semiconductor device A12, the first engagement portion 133 of the first power terminal 13 includes the first butt surface 132C and the auxiliary concave portion 132E. The second engagement portion 714 of the first extension terminal 71 includes a second butt surface 716 and an auxiliary convex portion 717.

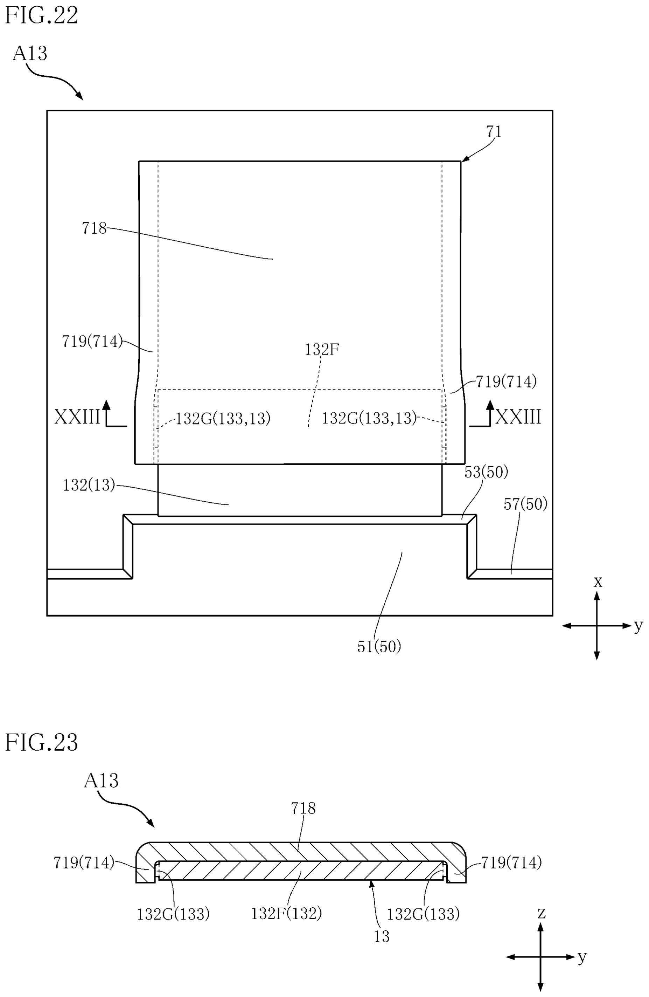

Next, a semiconductor device A13 according to a third variation of the first embodiment of the present disclosure will be described based on Figs. 22 and 23. Fig. 22 corresponds to Fig. 14, which shows semiconductor device A10. In the semiconductor device A13, the configuration of the first engagement portion 133 of the first power terminal 13 and the second engagement portion 714 of the first extension terminal 71 is different from that of the semiconductor device A10.

As shown in Figs. 22 and 23, the first exposed portion 132 of the first power terminal 13 has a base portion 132F and two step portions 132G. The base portion 132F protrudes from the first side surface 53 of the first sealing resin 50 in the second direction x. The two step portions 132G are located on both sides in the third direction y of the base portion 132F. Each of the two step portions 132G protrudes in the third direction y from the base portion 132F.

As shown in Figs. 22 and 23, the first extension terminal 71 has a main portion 718 and two side portions 719. As viewed in the first direction z, the main portion 718 overlaps the base portion 132F of the first exposed portion 132 of the first power terminal 13. The two side portions 719 are connected to both sides in the third direction y of the main portion 718. The two side portions 719 are individually opposed to the two step portions 132G of the first exposed portion 132. Each of the two step portions 132 is individually subjected to a compressive force from the two side portions 719.

In semiconductor device A13, the first engagement portion 133 of the first power terminal 13 includes two step portions 132G. The second engagement portion 714 of the first extension terminal 71 includes two side portions 719.

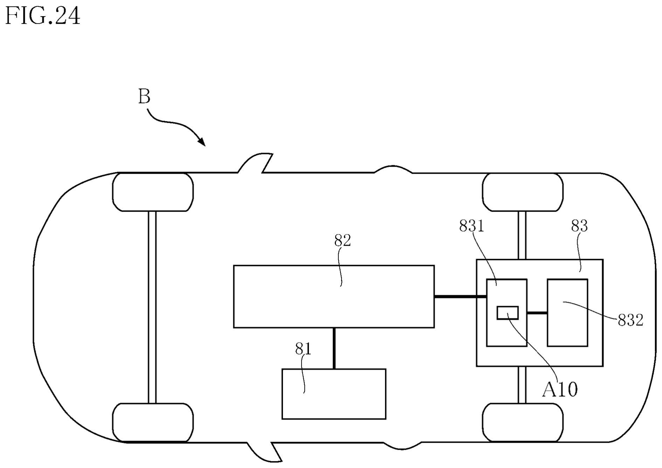

Next, a vehicle B in which the semiconductor device A10 is mounted will be described based on Fig. 24. The vehicle B is, for example, an electric vehicle (EV).

As shown in Fig. 24, the vehicle B is equipped with an on-board charger 81, a storage battery 82, and a drive system 83. The on-board charger 81 is supplied with electric power wirelessly from a power supply facility (not shown) installed outdoors. In addition, the means of supplying power from the power supply facility to the on-board charger 81 may be wired. The on-board charger 81 is configured with a boost type DC-DC converter. The voltage of the power supplied to the on-board charger 81 is boosted by the converter and then fed to the storage battery 82. The boosted voltage is, for example, 600 V.

Drive system 83 drives the vehicle B. The drive system 83 has an inverter 831 and a drive source 832. The semiconductor device A10 constitutes a part of the inverter 831. Electric power stored in storage battery 82 is fed to the inverter 831. The power fed from storage battery 82 to the inverter 831 is DC power. In addition, unlike the power system shown in Fig. 24, a boost type DC-DC converter may be further installed between the storage battery 82 and the inverter 831. The inverter 831 converts DC power to AC power. The inverter 831, including the semiconductor device A10, is conductive to the drive source 832. The drive source 832 has an AC motor and transmission. When the AC power converted by the inverter 831 is supplied to the drive source 832, the AC motor rotates and its rotation is transmitted to the transmission. The transmission rotates the drive shaft of the vehicle B after reducing the rotational speed transmitted from the AC motor as appropriate. As a result, the vehicle B is driven. In order to drive the vehicle B, it is necessary to freely control the rotational speed of the AC motor based on information such as the amount of variation of the accelerator pedal. Therefore, the semiconductor device A10 in the inverter 831 is necessary to output AC power whose frequency is varied appropriately to correspond to the required rotational speed of the AC motor.

Next, the effects of the semiconductor device A10 will be described.

The semiconductor device A10 has the first conductive layer 121, the first semiconductor element 21, the first power terminal 13, the first sealing resin 50, and the first extension terminal 71. The first power terminal 13 has a first exposed portion 132 that is exposed externally from the first sealing resin 50. The first extension terminal 71 is conductively bonded to the first exposed portion 132. By adopting this configuration, the size and shape of the first exposed portion 132 for external connection of the semiconductor device A10 can be set more freely. Therefore, according to this configuration, it is possible to increase the degree of freedom for the external connection of the power terminal in the semiconductor device A10.

A first engagement portion 133 is provided on the first exposed portion 132 of the first power terminal 13. The first extension terminal 71 is provided with a second engagement portion 714 that contacts the first engagement portion 133. By adopting this configuration, the first engagement portion 133 and the second engagement portion 714 can be utilized as a means for positioning the first extension terminal 71 with respect to the first exposed portion 132 when conductively bonding the first extension terminal 71 to the first exposed portion 132.

In the semiconductor device A10, the first engagement portion 133 includes the convex portion 132A of the first exposed portion 132 of the first power terminal 13. The second engagement portion 714 includes the concave portion 715 of the first extension terminal 71. The convex portion 132A is fitted into the concave portion 715 to thereby regulate misalignment of the first extension terminal 71 with respect to the first exposed portion 132 in a direction orthogonal to the first direction z.

In the semiconductor device A11, the first engagement portion 133 includes the first butt surface 132C of the first exposed portion 132 of the first power terminal 13. The second engagement portion 714 includes the second butt surface 716 of the first extension terminal 71. The second butt surface 716 contacts the first butt surface 132C to thereby regulate misalignment of the first extension terminal 71 with respect to the first exposed portion 132 in the second direction x.

In the semiconductor device A12, the first engagement portion 133 includes the first butt surface 132C and the auxiliary concave portion 132E of the first exposed portion 132 of the first power terminal 13. The second engagement portion 714 includes the second butt surface 716 and the auxiliary convex portion 717 of the first extension terminal 71. The second butt surface 716 contacts the first butt surface 132C and the auxiliary convex portion 717 is fitted into the auxiliary concave portion 132E to thereby regulate misalignment of the first extension terminal 71 with respect to the first exposed portion 132 in a direction orthogonal to the first direction z.

In the semiconductor device A13, the first engagement portion 133 includes two step portions 132G of the first exposed portion 132 of the first power terminal 13. The second engagement portion 714 includes two side portions 719 of the first extension terminal 71. the two side portions 719 individually contact the two step portions 132G to thereby regulate misalignment of the first extension terminal 71 with respect to the first exposed portion 132 in each of the second direction x and third direction y.

### Second embodiment:

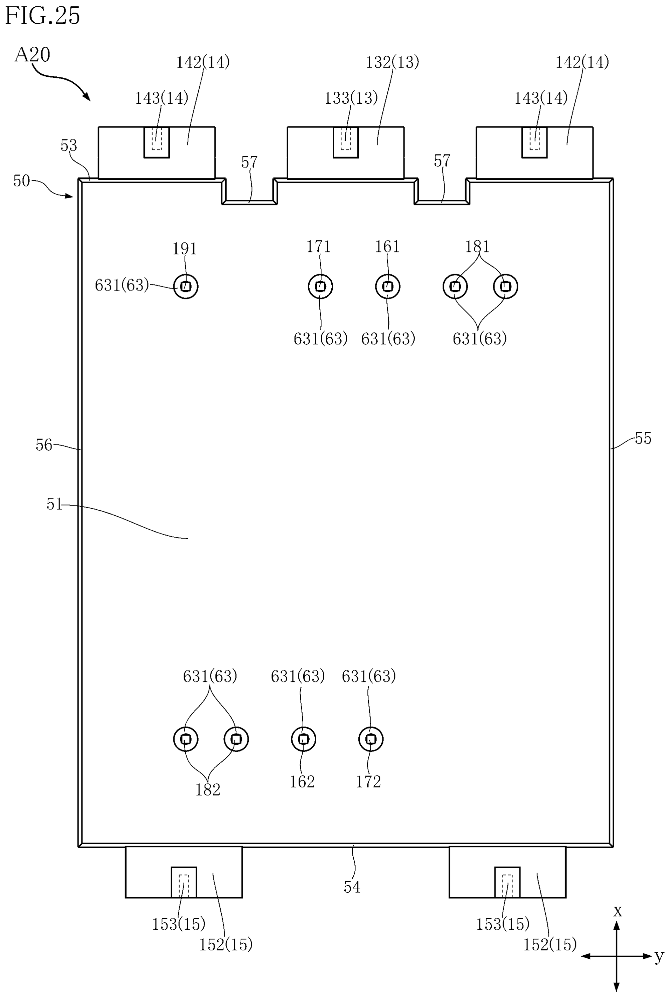

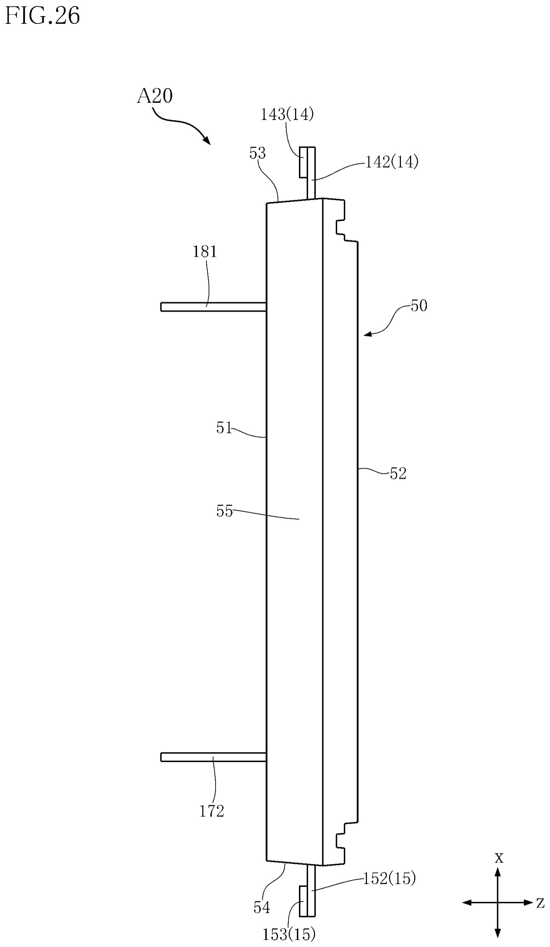

A semiconductor device A20 according to a second embodiment of the present disclosure will be described based on Figs. 25 and 26. In these figures, elements identical or similar to those of the semiconductor device A10 described above are marked with the same symbols, and redundant descriptions are omitted.

The semiconductor device A20 differs from the semiconductor device A10 in that it does not have the first extension terminal 71, the two second extension terminals 72, and the third extension terminal 73.

As shown in Fig. 25, the first engagement portion 133 is provided in the first exposed portion 132 of the first power terminal 13. The configuration of the first engagement portion 133 is equivalent to the configuration of the first engagement portion 133 of the semiconductor device A10. As shown in Figs. 25 and 26, the third engagement portion 143 is provided at the second exposed portion 142 of each of the two second power terminals 14. The configuration of the third engagement portion 143 is equivalent to the configuration of the third engagement portion 143 of the semiconductor device A10. The fifth engagement portion 153 is provided on each of the two third power terminals 15. The configuration of the fifth engagement portion 153 is equivalent to the configuration of the fifth engagement portion 153 of the semiconductor device A10.

Next, the effects of the semiconductor device A20 will be described.

The semiconductor device A20 is provided with the first conductive layer 121, the first semiconductor element 21, the first power terminal 13, and the first sealing resin 50. The first power terminal 13 has the first exposed portion 132 that is exposed externally from the first sealing resin 50. The first exposed portion 132 has the first engagement portion 133. By adopting this configuration, the first engagement portion 133 can be used as a means for positioning the first extension terminal 71 with respect to the first exposed portion 132 when conductively bonding the first extension terminal 71 to the first exposed portion 132. As a result, the size and shape of the first exposed portion 132 for external connection of the semiconductor device A20 can be set more freely. Therefore, according to this configuration, it is possible to increase the degree of freedom for the external connection of the power terminal in the semiconductor device A20.

### Third embodiment:

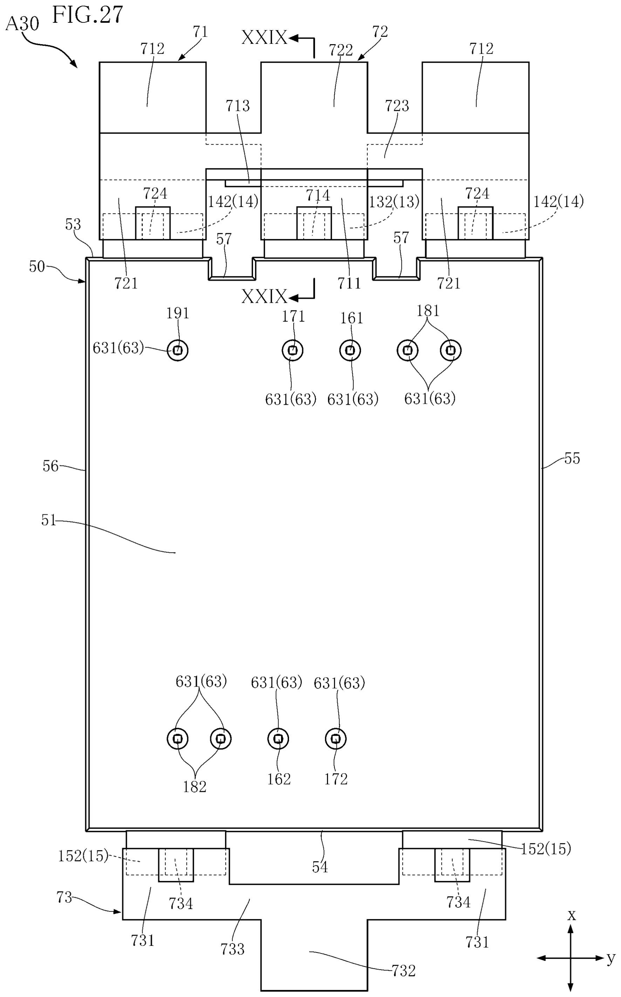

A semiconductor device A30 in a third embodiment of the present disclosure will be described based on Figs. 27 to 29. In these figures, elements identical or similar to those of the semiconductor device A10 described above are marked with the same symbols, and redundant descriptions are omitted.

In the semiconductor device A30, the configuration of the first extension terminal 71 and the fact that one second extension terminal 72 is provided instead of two second extension terminals 72 are different from those of semiconductor device A10.

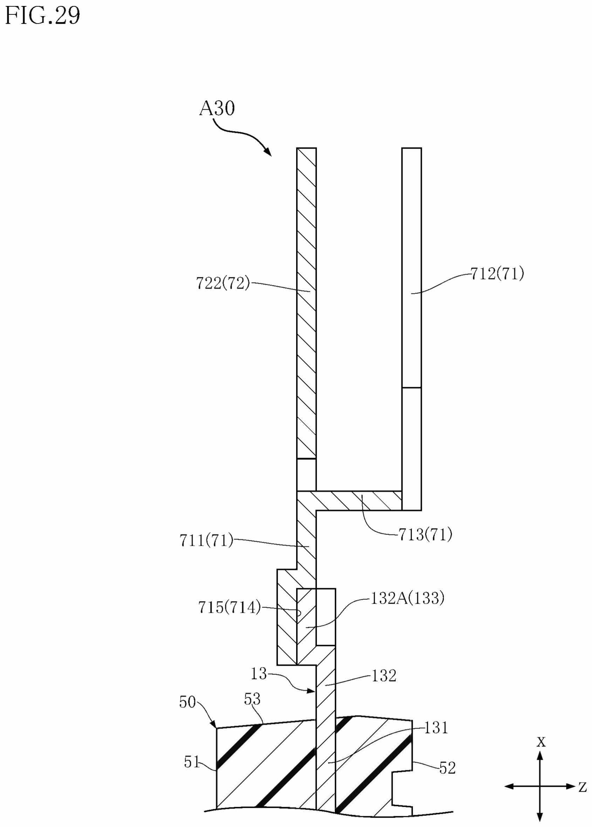

As shown in Figs. 27 and 29, the first extension terminal 71 has an internal connecting portion 711, two external connecting portions 712, and a coupling portion 713. The internal connecting portion 711 is conductively bonded to the first exposed portion 132 of the first power terminal 13. The two external connecting portions 712 are located opposite the internal connecting portion 711 with respect to the coupling portion 713. The two external connecting portions 712 are separated from each other in the third direction y. The coupling portion 713 couples the internal connecting portion 711 and the two external connecting portions 712.

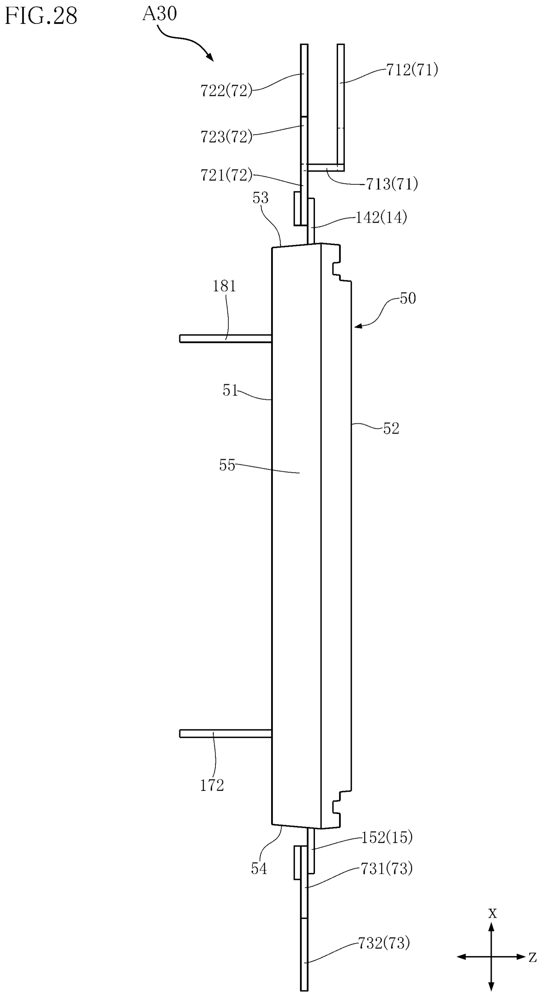

As shown in Figs. 27 and 28, the second extension terminal 72 has two internal connecting portions 721, an external connecting portion 722 and a coupling portion 723. The two internal connecting portions 721 are individually conductively bonded to the second exposed portion 142 of each of the two second power terminals 14. The external connecting portion 722 is located opposite the two internal connecting portions 721 with respect to the coupling portion 723. The coupling portion 723 couples the two internal connecting portions 721 and the external connecting portion 722.

As shown in Fig. 27, as viewed in the first direction z, the second extension terminal 72 overlaps the first extension terminal 71. The external connecting portion 722 of the second extension terminal 72 is located between the two external connecting portions 712 of the first extension terminal 71 in the third direction y. In the first direction z, the two external connecting portions 712 are located close to the bottom surface 52 of the first sealing resin 50 more than the external connecting portion 722 is.

Next, the effects of the semiconductor device A30 will be described.

The semiconductor device A30 is provided with the first conductive layer 121, the first semiconductor element 21, the first power terminal 13, the first sealing resin 50, and the first extension terminal 71. The first power terminal 13 has a first exposed portion 132 that is exposed externally from the first sealing resin 50. The first extension terminal 71 is conductively bonded to the first exposed portion 132. Therefore, according to this configuration, it is possible to increase the degree of freedom for the external connection of the power terminal in the semiconductor device A30. Furthermore, the semiconductor device A30 exhibits the same effects as the semiconductor device A10 by having the configuration in common with the semiconductor device A10.

### Fourth embodiment:

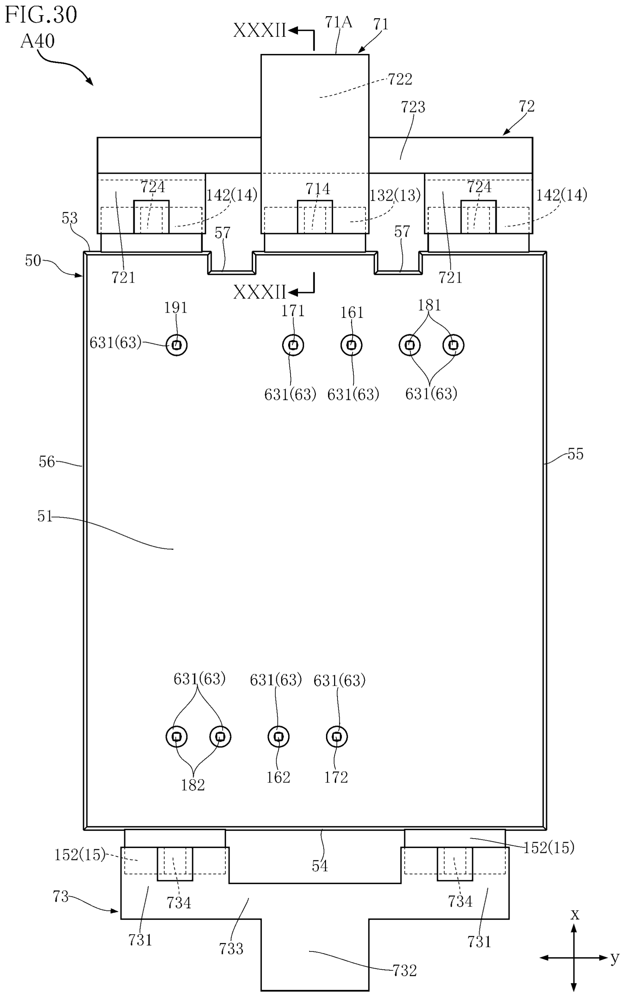

A semiconductor device A40 of a fourth embodiment of the present disclosure will be described based on Figs. 30 to 32. In these figures, elements identical or similar to those of the semiconductor device A10 and the semiconductor device A30 described above are marked with the same symbols, and redundant descriptions are omitted.

In the semiconductor device A40, the configuration of the first extension terminal 71 and the second extension terminal 72 differs from that of semiconductor device A30.

As shown in Fig. 30, the first extension terminal 71 is not provided with the internal connecting portion 711, the two external connecting portions 712, and the coupling portion 713 as in the case of the semiconductor device A10. As shown in Figs. 30 to 32, as viewed in the first direction z, the first extension terminal 71 has a first tip portion 71A located farthest from the first sealing resin 50.

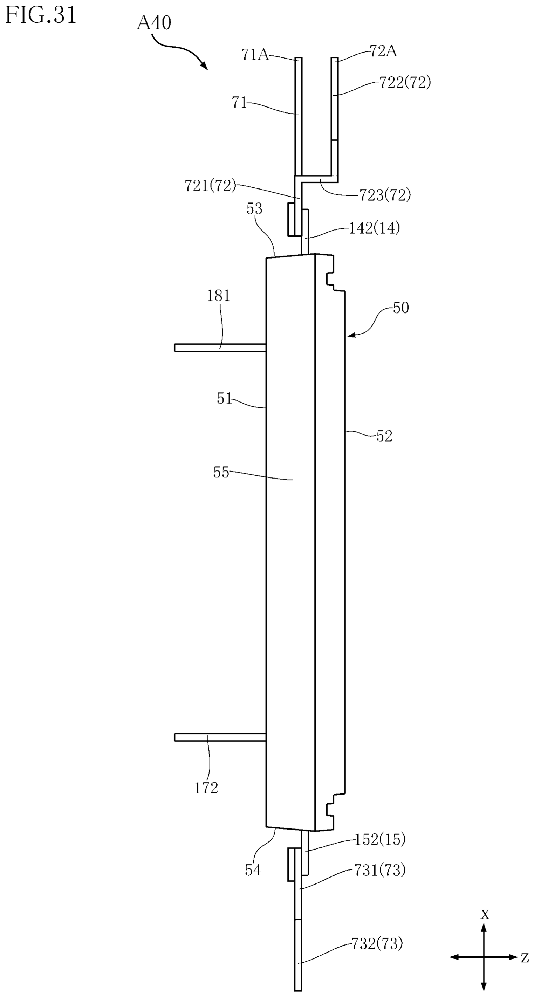

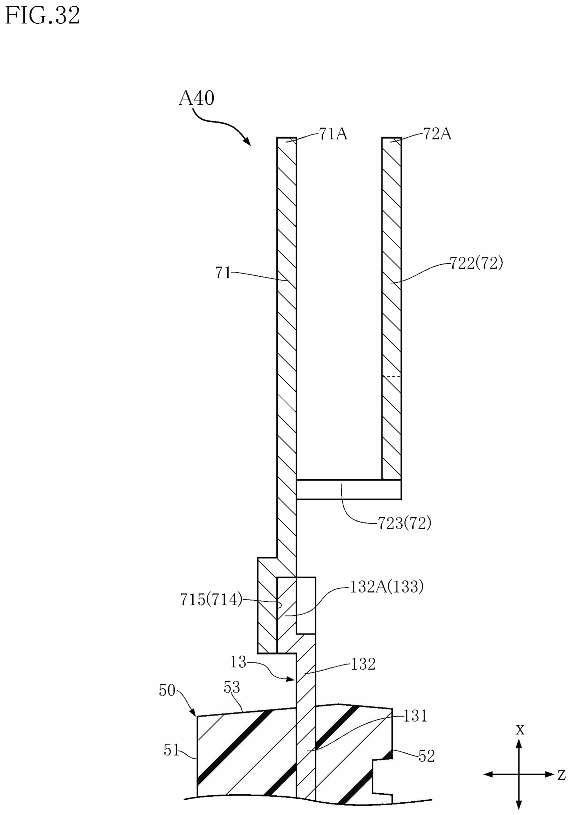

As shown in Figs. 31 and 32, as viewed in the first direction z, the second extension terminal 72 has a second tip portion 72A located farthest from the first sealing resin 50. As viewed in the first direction z, the second tip portion 72A overlaps the first tip portion 71A of the first extension terminal 71. In the first direction z, the second tip portion 72A is located close to the bottom surface 52 of the first sealing resin 50 more than the first tip portion 71A is.

Next, the effects of the semiconductor device A40 will be described.

The semiconductor device A40 is provided with the first conductive layer 121, the first semiconductor element 21, the first power terminal 13, the first sealing resin 50, and the first extension terminal 71. The first power terminal 13 has the first exposed portion 132 that is exposed externally from the first sealing resin 50. The first extension terminal 71 is conductively bonded to the first exposed portion 132. Therefore, according to this configuration, it is possible to increase the degree of freedom for the external connection of the power terminal in the semiconductor device A40. Furthermore, the semiconductor device A40 exhibits the same effects as the semiconductor device A10 by having the configuration in common with the semiconductor device A10.

In the semiconductor device A40, the first extension terminal 71 has the first tip portion 71A. The second extension terminal 72 has the second tip portion 72A. As viewed in the first direction z, the second tip portion 72A overlaps the first tip portion 71A. By adopting this configuration, when a bus bar is connected to the first extension terminal 71 and the second extension terminal 72, the size of the bus bar can be made more compact.

### Fifth embodiment:

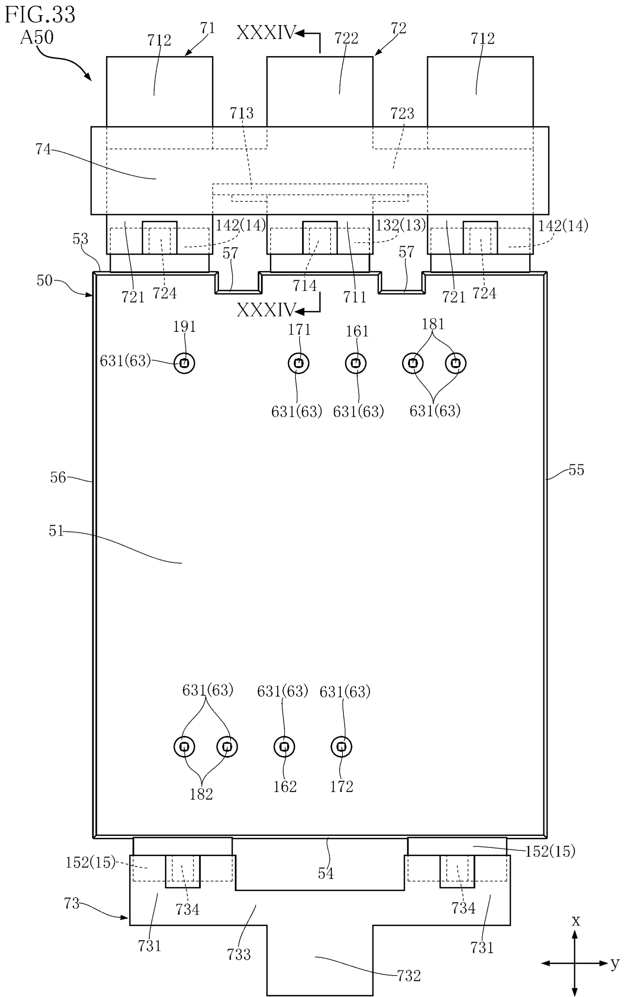

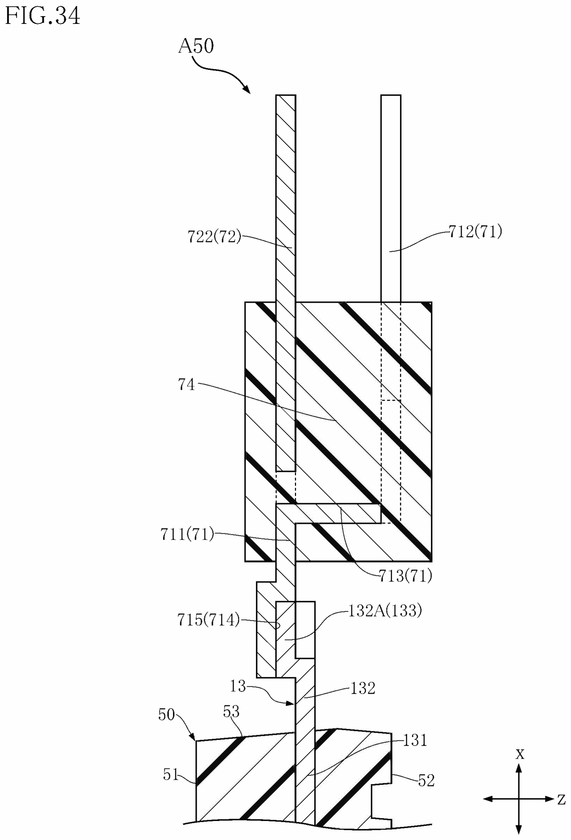

Based on Figs. 33 and 34, a semiconductor device A50 according to a fifth embodiment of the present disclosure will be described. In these figures, elements identical or similar to those of the semiconductor device A10 and semiconductor device A30 described above are marked with the same symbol, and redundant descriptions are omitted.

The semiconductor device A50 differs from the semiconductor device A30 in that it further comprises a second sealing resin 74.

As shown in Figs. 33 and 34, the second sealing resin 74 covers a part of each of the first extension terminal 71 and the second extension terminals 72. Each of the internal connecting portion 711 of the first extension terminal 71 and the two external connecting portions 712 of the first extension terminal 71 is exposed externally from the second sealing resin 74. Each of the two internal connecting portions 721 of the second extension terminal 72 and the external connecting portion 722 of the second extension terminal 72 are exposed externally from the second sealing resin 74.

Next, the effects of the semiconductor device A50 will be described.

A semiconductor device A50 is provided with the first conductive layer 121, the first semiconductor element 21, the first power terminal 13, the first sealing resin 50, and the first extension terminal 71. The first power terminal 13 has the first exposed portion 132 that is exposed externally from the first sealing resin 50. The first extension terminal 71 is conductively bonded to the first exposed portion 132. Therefore, according to this configuration, it is possible to increase the degree of freedom for the external connection of the power terminal in the semiconductor device A50. Furthermore, the semiconductor device A50 exhibits the same effects as the semiconductor device A10 by having the configuration in common with the semiconductor device A10.

The semiconductor device A50 further comprises a second sealing resin 74 that covers a part of each of the first extension terminal 71 and the second extension terminal 72. By adopting this configuration, the first extension terminal 71 and the second extension terminal 72 become an integral structure with the second sealing resin 74. As a result, it becomes easier to conductively bond the first extension terminal 71 to the first exposed portion 132 of the first power terminal 13 and the second extension terminal 72 to the second exposed portion 142 of the second power terminal 14.

### Sixth embodiment:

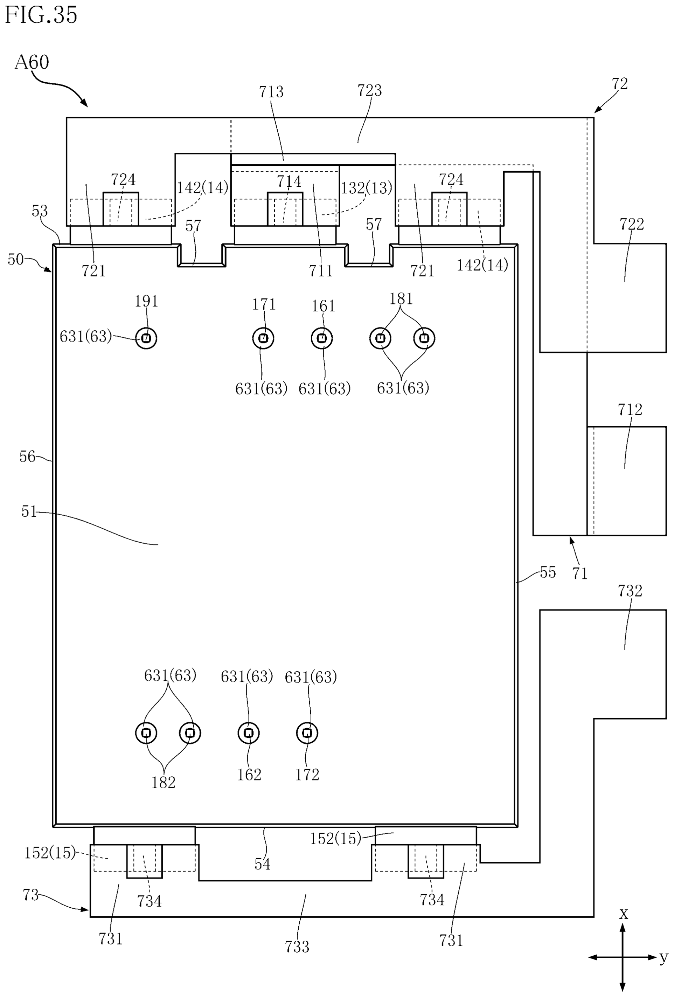

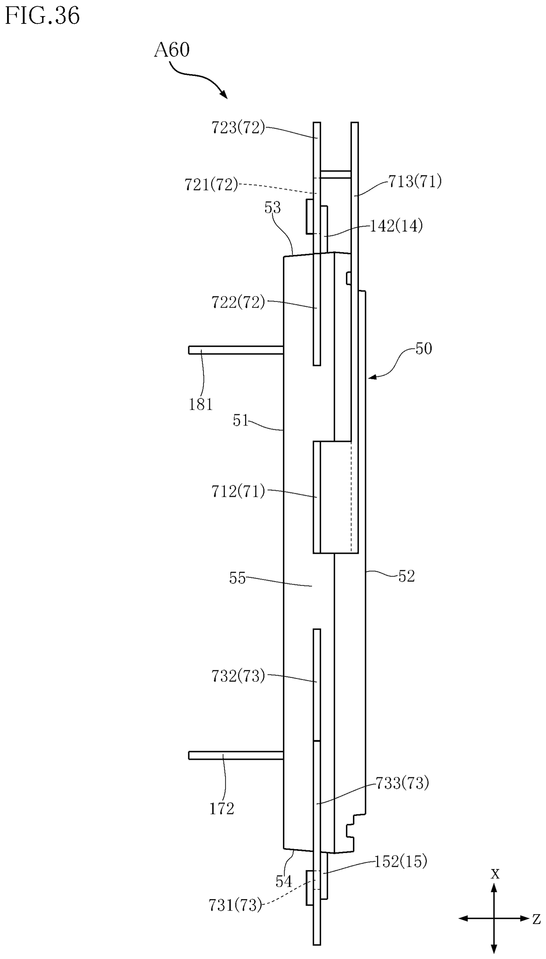

Based on Figs. 35 and 36, a semiconductor device A60 according to a sixth embodiment of the present disclosure will be described. In these figures, elements identical or similar to those of the semiconductor device A10 and semiconductor device A30 described above are marked with the same symbol, and redundant descriptions are omitted.

In the semiconductor device A60, the configuration of the first extension terminal 71, the second extension terminal 72, and the third extension terminal 73 differs from that of semiconductor device A30.

As shown in Fig. 35, the first extension terminal 71 differs from that of the semiconductor device A30 in that it has one external connecting portion 712 instead of the two external connecting portions 712. As shown in Figs. 35 and 36, each of the external connecting portion 712 of the first extension terminal 71, the external connecting portion 722 of the second extension terminal 72, and the external connecting portion 732 of the third extension terminal 73 is located opposite the fourth side surface 56 with respect to the third side surface 55 of the first sealing resin 50.

Next, the effects of the semiconductor device A60 will be described.

The semiconductor device A60 is provided with the first conductive layer 121, the first semiconductor element 21, the first power terminal 13, the first sealing resin 50, and the first extension terminal 71. The first power terminal 13 has a first exposed portion 132 that is exposed externally from the first sealing resin 50. The first extension terminal 71 is conductively bonded to the first exposed portion 132. Therefore, according to this configuration, it is possible to increase the degree of freedom for external connection of the power terminal in the semiconductor device A60. Furthermore, the semiconductor device A60 exhibits the same effects as the semiconductor device A10 by having the configuration in common with the semiconductor device A10.

The present disclosure is not limited to the aforementioned embodiments. The specific configuration of each part of the disclosure can be designed and modified in various ways.

The present disclosure includes the embodiments described in the following clauses.

### Clause 1.

A semiconductor device comprising:
a first conductive layer;
a first semiconductor element bonded to one side in a first direction of the first conductive layer;
a first power terminal conductive to the first conductive layer and the first semiconductor element;
a first sealing resin covering the first conductive layer and the first semiconductor element; and
a first extension terminal conductively bonded to the first power terminal,
wherein the first power terminal has a first exposed portion exposed externally from the first sealing resin, and
the first extension terminal is conductively bonded to the first exposed portion.

### Clause 2.

semiconductor device comprising:
a first conductive layer;
a first semiconductor element bonded to one side in a first direction of the first conductive layer;
a first power terminal conductive to the first conductive layer and the first semiconductor element; and
a first sealing resin covering the first conductive layer and the first semiconductor element,
wherein the first power terminal has a first exposed portion exposed externally from the first sealing resin, and
the first exposed portion is provided with a first engagement portion.

### Clause 3.

The semiconductor device according to clause 1,
Wherein the first exposed portion is provided with a first engagement portion, and
the first extension terminal is provided with a second engagement portion that contacts the first engagement portion.

### Clause 4.

The semiconductor device according to clause 2, further comprising a first extension terminal conductively bonded to the first exposed portion,
wherein the first extension terminal is provided with a second engagement portion that contacts the first engagement portion.

### Clause 5.

The semiconductor device according to clause 3 or 4,
wherein the first exposed portion is provided with a convex portion protruding to one side in the first direction,
the first extension terminal is provided with a concave portion that is recessed toward the side toward which the convex portion protrudes in the first direction,
the first engagement portion includes the convex portion, and
the second engagement portion includes the concave portion.

### Clause 6.

The semiconductor device according to clause 3 or 4,
wherein the first exposed portion has an end surface facing a side opposite a side on which the first sealing resin is located in a second direction orthogonal to the first direction, a first butt surface facing a same side as the end surface in the second direction, and an intermediate surface facing the first direction,
the first butt surface is located between the end surface and the first sealing resin in the second direction,
the intermediate surface is located between the end surface and the first butt surface in the first direction and overlaps the first extension terminal as viewed in the first direction,
the first extension terminal has a second butt surface opposite the first butt surface,
the first engagement portion includes the first butt surface, and
the second engagement portion includes the second butt surface.

### Clause 7.

The semiconductor device according to clause 6,
wherein the first exposed portion has an auxiliary concave portion recessed from the first butt surface,
the first extension terminal is provided with an auxiliary convex portion protruding from the second butt surface,
the first engagement portion includes the auxiliary concave portion, and
the second engagement portion includes the auxiliary convex portion.

### Clause 8.

The semiconductor device according to clause 3 or 4,
wherein the first exposed portion has a base portion protruding from the first sealing resin in a second direction orthogonal to the first direction, and two step portions located on both sides in a third direction orthogonal to the first direction and the second direction of the base portion,
the first extension terminal has a main portion overlapping the base portion as viewed in the first direction and two side portions connecting both sides in the third direction of the main portion,
each of the two step portions protrudes from the base portion in the third direction,
the two side portions are individually opposed to the two step portions,
the first engagement portion includes the two step portions, and
the second engagement portion includes the two side portions.

### Clause 9.

The semiconductor device according to clause 3 or 4, further comprising:
a second semiconductor element conductive to the first semiconductor element and covered by the first sealing resin;
a second power terminal conductive to the second semiconductor element; and
a second extension terminal conductively bonded to the second power terminal,
wherein the second power terminal has a second exposed portion exposed externally from the first sealing resin, and
the second extension terminal is conductively bonded to the second exposed portion.

### Clause 10.

The semiconductor device according to clause 9, wherein as viewed in the first direction, the second extension terminal overlaps the first extension terminal.

### Clause 11.

The semiconductor device according to clause 10,
wherein as viewed in the first direction, the first extension terminal has a first tip portion located farthest from the first sealing resin,
as viewed in the first direction, the second extension terminal has a second tip portion located farthest from the first sealing resin, and
as viewed in the first direction, the second tip portion overlaps the first tip portion.

### Clause 12.

The semiconductor device according to clause 9, further comprising a second sealing resin covering a part of each of the first extension terminal and the second extension terminal.

### Clause 13.

The semiconductor device according to clause 9, further comprising a second conductive layer covered by the first sealing resin,
wherein the first semiconductor element is conductively bonded to the first conductive layer, and
the second semiconductor element is conductively bonded to the second conductive layer.

### Clause 14.

The semiconductor device according to clause 13, further comprising:
a third power terminal conductive to the second conductive layer; and
a third extension terminal conductively bonded to the third power terminal,
wherein the third power terminal has a third exposed portion exposed externally from the first sealing resin, and
the third extension terminal is conductively bonded to the third exposed portion.

### Clause 15.

The semiconductor device according to clause 14,
wherein the first sealing resin has a first side surface and a second side surface facing opposite each other in a second direction orthogonal to the first direction,
each of the first exposed portion and the second exposed portion is exposed externally from the first side surface, and
the third exposed portion is exposed externally from the second side surface.

### Clause 16.

The semiconductor device according to clause 15,
wherein the first sealing resin has a third side surface and a fourth side surface facing opposite each other in a third direction orthogonal to the first direction and the second direction, and
each of the first extension terminal, the second extension terminal, and the third extension terminal includes a part located opposite the fourth side surface with respect to the third side surface.

### Clause 17.

A vehicle comprising:
a drive source; and
a semiconductor device according to clause 14,
wherein the semiconductor device is conductive to the drive source.

### REFERENCE NUMERALS

A10, A20, A30, A40: Semiconductor device B: Vehicle
11: Base material 111: Insulating layer
112: Intermediate layer 113: Heat dissipation layer
113A: Base surface 113B: Recessed area
121: First conductive layer 121A: First main surface
122: Second conductive layer 122A: Second main surface
129: First bonding layer 13: First power terminal
131: First covered portion 132: First exposed portion
132A: Convex portion 132B: End surface
132C: First butt surface 132D: Intermediate surface
132E: Auxiliary concave portion 132F: Base portion
132G: Step portion 133: First engagement portion
14: Second power terminal 141: Second covered portion
142: Second exposed portion 143: Third engagement portion
15: Third power terminal 151: Third covered portion
152: Third exposed portion 153: Fifth engagement portion
161: First signal terminal 162: Second signal terminal
171: Third signal terminal 172: Fourth signal terminal
181: Fifth signal terminal 182: Sixth signal terminal
191: Seventh signal terminal 192: Eighth signal terminal
20: Semiconductor element 21: First semiconductor element
211: First electrode 212: Second electrode
213: First gate electrode 214: First detection electrode
22: Second semiconductor element 221: Third electrode
222: Fourth electrode 223: Second gate electrode
224: Second detection electrode 23: Thermistor
29: Conductive bonding layer 31: First conductive member
311: Body portion 312: First bonding portion
313: First coupling portion 314: Second bonding portion
315: Second coupling portion 32: Second conductive member
321: Body portion 322: Third bonding portion
323: Third coupling portion 324: Fourth bonding portion
325: Fourth coupling portion 326: Intermediate portion
327: Transverse beam portion 41-47: First wire to Seventh wire
50: First sealing resin 51: Top surface
52: Bottom surface 53: First side surface
54: Second side surface 55: Third side surface
56: Fourth side surface 57: Concave portion
61: First wiring 611: First mounting layer
612: First metal layer 613: First gate wiring layer
614: First detection wiring layer 615: First temperature detection wiring layer
616: Second detection wiring layer 62: Second wiring
621: Second mounting layer 622: Second metal layer
623: Second gate wiring layer 624: Third detection wiring layer
625: Second temperature detection wiring layer 626: Fourth detection wiring layer
63: Sleeve 631: End surface
68: Second bonding layer 69: Third bonding layer
71: First extension terminal 711: Internal connecting portion
712: External connecting portion 713: Coupling portion
714: Second engagement portion 715: Concave portion
716: Second butt surface 717: Auxiliary convex portion
718: Main portion 719: Side portion
72: Second extension terminal 721: Internal connecting portion
722: External connecting portion 723: Coupling portion
724: Fourth engagement portion 73: Third extension terminal
731: Internal connecting portion 732: External connecting portion
733: Coupling portion 734: Sixth engagement portion
74: Second sealing resin 80: Rapid power supply facility
81: Converter 81: On-board charger
82: Storage battery 83: Drive system
831: Inverter 832: Drive source
z: First direction x: Second direction
y: Third direction

## Claims

1. A semiconductor device comprising:
a first conductive layer;
a first semiconductor element bonded to one side in a first direction of the first conductive layer;
a first power terminal conductive to the first conductive layer and the first semiconductor element;
a first sealing resin covering the first conductive layer and the first semiconductor element; and
a first extension terminal conductively bonded to the first power terminal,
wherein the first power terminal has a first exposed portion exposed externally from the first sealing resin, and
the first extension terminal is conductively bonded to the first exposed portion.

2. A semiconductor device comprising:
a first conductive layer;
a first semiconductor element bonded to one side in a first direction of the first conductive layer;
a first power terminal conductive to the first conductive layer and the first semiconductor element; and
a first sealing resin covering the first conductive layer and the first semiconductor element,
wherein the first power terminal has a first exposed portion exposed externally from the first sealing resin, and
the first exposed portion is provided with a first engagement portion.

3. The semiconductor device according to claim 1,
Wherein the first exposed portion is provided with a first engagement portion, and
the first extension terminal is provided with a second engagement portion that contacts the first engagement portion.

4. The semiconductor device according to claim 2, further comprising a first extension terminal conductively bonded to the first exposed portion,
wherein the first extension terminal is provided with a second engagement portion that contacts the first engagement portion.

5. The semiconductor device according to claim 3 or 4,
wherein the first exposed portion is provided with a convex portion protruding to one side in the first direction,
the first extension terminal is provided with a concave portion that is recessed toward the side toward which the convex portion protrudes in the first direction,
the first engagement portion includes the convex portion, and
the second engagement portion includes the concave portion.

6. The semiconductor device according to claim 3 or 4,
wherein the first exposed portion has an end surface facing a side opposite a side on which the first sealing resin is located in a second direction orthogonal to the first direction, a first butt surface facing a same side as the end surface in the second direction, and an intermediate surface facing the first direction,
the first butt surface is located between the end surface and the first sealing resin in the second direction,
the intermediate surface is located between the end surface and the first butt surface in the first direction and overlaps the first extension terminal as viewed in the first direction,
the first extension terminal has a second butt surface opposite the first butt surface,
the first engagement portion includes the first butt surface, and
the second engagement portion includes the second butt surface.

7. The semiconductor device according to claim 6,
wherein the first exposed portion has an auxiliary concave portion recessed from the first butt surface,
the first extension terminal is provided with an auxiliary convex portion protruding from the second butt surface,
the first engagement portion includes the auxiliary concave portion, and
the second engagement portion includes the auxiliary convex portion.

8. The semiconductor device according to claim 3 or 4,
wherein the first exposed portion has a base portion protruding from the first sealing resin in a second direction orthogonal to the first direction, and two step portions located on both sides in a third direction orthogonal to the first direction and the second direction of the base portion,
the first extension terminal has a main portion overlapping the base portion as viewed in the first direction and two side portions connecting both sides in the third direction of the main portion,
each of the two step portions protrudes from the base portion in the third direction,
the two side portions are individually opposed to the two step portions,
the first engagement portion includes the two step portions, and
the second engagement portion includes the two side portions.

9. The semiconductor device according to claim 3 or 4, further comprising:
a second semiconductor element conductive to the first semiconductor element and covered by the first sealing resin;
a second power terminal conductive to the second semiconductor element; and
a second extension terminal conductively bonded to the second power terminal,
wherein the second power terminal has a second exposed portion exposed externally from the first sealing resin, and
the second extension terminal is conductively bonded to the second exposed portion.

10. The semiconductor device according to claim 9, wherein as viewed in the first direction, the second extension terminal overlaps the first extension terminal.

11. The semiconductor device according to claim 10,
wherein as viewed in the first direction, the first extension terminal has a first tip portion located farthest from the first sealing resin,
as viewed in the first direction, the second extension terminal has a second tip portion located farthest from the first sealing resin, and
as viewed in the first direction, the second tip portion overlaps the first tip portion.

12. The semiconductor device according to claim 9, further comprising a second sealing resin covering a part of each of the first extension terminal and the second extension terminal.

13. The semiconductor device according to claim 9, further comprising a second conductive layer covered by the first sealing resin,
wherein the first semiconductor element is conductively bonded to the first conductive layer, and
the second semiconductor element is conductively bonded to the second conductive layer.

14. The semiconductor device according to claim 13, further comprising:
a third power terminal conductive to the second conductive layer; and
a third extension terminal conductively bonded to the third power terminal,
wherein the third power terminal has a third exposed portion exposed externally from the first sealing resin, and
the third extension terminal is conductively bonded to the third exposed portion.

15. The semiconductor device according to claim 14,
wherein the first sealing resin has a first side surface and a second side surface facing opposite each other in a second direction orthogonal to the first direction,
each of the first exposed portion and the second exposed portion is exposed externally from the first side surface, and
the third exposed portion is exposed externally from the second side surface.

16. The semiconductor device according to claim 15,
wherein the first sealing resin has a third side surface and a fourth side surface facing opposite each other in a third direction orthogonal to the first direction and the second direction, and
each of the first extension terminal, the second extension terminal, and the third extension terminal includes a part located opposite the fourth side surface with respect to the third side surface.

17. A vehicle comprising:
a drive source; and
a semiconductor device according to claim 14,
wherein the semiconductor device is conductive to the drive source.
